# EUROPEAN PATENT SPECIFICATION

(11) **EP 3 162 868 B1**
(45) Date of publication and mention of the grant of the patent: **05.10.2022**
(21) Application number: 15812604.5
(22) Date of filing: 26.06.2015
(51) Int. Cl.: C09K 3/00, C08K 5/17, C08L 101/00, G03F 7/004

(54) **THERMAL BASE GENERATOR, THERMOSETTING RESIN COMPOSITION, CURED FILM, CURED FILM MANUFACTURING METHOD, AND SEMICONDUCTOR DEVICE**
GENERATOR EINER THERMISCHEN BASIS, WÄRMEHÄRTENDE HARZZUSAMMENSETZUNG, GEHÄRTETER FILM, VERFAHREN ZUR HERSTELLUNG DES GEHÄRTETEN FILMS UND HALBLEITERBAUELEMENT
GÉNÉRATEUR DE BASE THERMIQUE, COMPOSITION DE RÉSINE THERMODURCISSABLE, FILM DURCI, PROCÉDÉ DE FABRICATION DE FILM DURCI, ET DISPOSITIF SEMI-CONDUCTEUR

(30) Priority: 27.06.2014 JP 2014132156; 02.10.2014 JP 2014203868; 24.02.2015 JP 2015034388
(43) Date of publication of application: 03.05.2017
(73) Proprietor: FUJIFILM Corporation, Tokyo 106-8620 (JP)
(72) Inventor: KOYAMA, Ichiro, Haibara-gun Shizuoka 421-0396 (JP)
(74) Representative: Hoffmann Eitle
(86) International application number: PCT/JP2015/068507
(87) International publication number: WO 2015/199219

(56) References cited:
- EP-A1- 1 887 423
- WO-A1-2009/136557
- JP-A- S57 189 131
- JP-A- 2002 265 531
- JP-A- 2007 056 196
- JP-A- 2011 202 139
- JP-A- 2013 139 566
- JP-A- 2014 001 375
- US-A- 4 892 944
- US-A1- 2009 246 700

## Description

### BACKGROUND OF THE INVENTION

### 1. Field of the Invention

The present invention relates to a thermal base generator, a thermosetting resin composition, a cured film, a cured film manufacturing method, and a semiconductor device. More specifically, the present invention relates to a thermal base generator which is capable of performing cyclization of a thermosetting resin at a low temperature. Further, the present invention relates to a thermosetting resin composition containing a thermal base generator, a cured film using a thermosetting resin composition, a cured film manufacturing method, and a semiconductor device.

### 2. Description of the Related Art

Thermosetting resins, such as a polyimide resin, a polyamideimide resin, and a polybenzoxazole resin, which are cyclized to be cured, exhibit excellent heat resistance and excellent insulating properties and are therefore used for, e.g., an insulating layer of semiconductor devices.

Further, the thermosetting resins have low solubility in a solvent and are therefore used in a state of a precursor resin (a polyimide precursor resin, a polyamideimide precursor resin, or a polybenzoxazole precursor resin) prior to being subjected to a cyclization reaction, which are then applied onto, e.g., a substrate, followed by heating to result in cyclization of the thermosetting resin, thus forming a cured film.

For example, JP2006-282880A discloses a photosensitive resin composition containing an N-aromatic glycine derivative and a polymer precursor. JP2006-282880A employs an N-aromatic glycine derivative as a photobase generator.

JP2007-56196A discloses a polyimide precursor resin composition containing a polyimide precursor, a thermal base generator composed of a neutral compound which generates a secondary amine by heating to cause thermal decomposition at a temperature of 200°C or lower, and a solvent.

Meanwhile, JP2009-237175A discloses a planographic printing plate precursor having an image forming layer containing an infrared absorber, a polymerization initiator, a polymerizable compound, a hydrophobic binder and an N-phenyliminodiacetic acid.

Further, JP2008-63553A discloses a laser-decomposable resin composition containing an N-phenyliminodiacetic acid and a binder polymer. JP 2011-202139 A discloses an adhesive composition comprising a thermosetting polyimide resin composition and an energy-sensitive base generator that generates a base by heat or energy rays. JP 2002-265531 A describes an ammonium salt of a cyanoacetic acid or acetoxyacetic acid anion and an ammonium cation as a base-generating compound. JP S57-189131 A relates to a thermally developable diazo-based copying material and uses an ammonium oxalate as a thermal base generator. JP 2014-001375 A describes tetramethylammonium phenylsulfonylacetate and tetramethylammonium phenylpropiolate as thermal base generator to obtain a cured membrane. JP 2013-139566 A discloses an imidazolium-salt based base generator for performing imidization for preparation of polyimide at lower temperatures. JP 2007-056196 A relates to a polyimide precursor composition inter alia containing a polyimide precursor, a thermal base generator which can be suitably used for producing a polyimide film at low temperature. WO 2009/136557 A1 describes a polyimide precursor comprising an acid dianhydride for the production of a photosensitive dry film. EP 1 887 423 A1 relates to a laser-decomposable resin composition comprising a compound including.a carboxyl group and/or a carboxylic acid anhydride and a binder polymer. US 2009/246700 A1 describes a method of manufacturing a lithographic printing plate precursor comprising an image forming layer and a support, wherein the image forming layer may comprise a carboxylic acid-based compound. US 4 892 944 A discloses a process for producing quaternary salts of high purity which method comprises reacting a tertiary amine or phosphine with a carbonic acid diester to form a corresponding quaternary carbonate and further mixing it with an acid to perform decarboxylation.

### SUMMARY OF THE INVENTION

Although thermosetting resins, such as a polyimide precursor resin, a polyamideimide precursor resin, and a polybenzoxazole precursor resin, which are cyclized by the action of a base to be cured, are capable of forming a cured film having excellent heat resistance, a heat treatment at a high temperature has been required for the cyclization reaction of these thermosetting resins. For this reason, in a case where an insulating layer of a semiconductor device is formed using such a thermosetting resin, heating during the cyclization reaction of a thermosetting resin may result in a risk of, e.g., thermal damage for example on an electronic component, correspondingly further lowering of a cyclization temperature is required.

In JP2006-282880A, as described in paragraph "0014", an object of the invention is to provide a photosensitive resin composition with which a great solubility contrast can be obtained regardless of the type of polyimide precursor resins, and consequently a pattern having a good shape can be obtained while maintaining a sufficient process margin. In order to achieve such an object, an N-aromatic glycine derivative is used as a photobase generator. That is, in JP2006-282880A, an exposed portion is cured by performing imidization of a polyimide precursor resin using an amine, which is generated by irradiating an N-aromatic glycine derivative with light, as a catalyst, whereby difference of solubility is given between the exposed portion and the unexposed portion.

However, in JP2006-282880A, consideration for lowering a cyclization temperature has not been made, and imidization has been carried out by heating at 300°C for 1 hour in the Examples.

In addition, in JP2006-282880A, there is no description or suggestion for a thermal base generator.

Although JP2007-56196A employs a thermal base generator composed of a neutral compound which generates a secondary amine through thermal decomposition by heating at a temperature of 200°C or lower, it was found according to the study of the present inventors that the thermal base generator is in an equilibrium state of dissociation and non-dissociation in the composition. For this reason, it was found that the cyclization reaction of a polyimide precursor resin is likely to proceed during preservation of the composition, thus resulting in gelation, and the stability is poor.

Meanwhile, JP2009-237175A and JP2008-63553A disclose use of carboxylic acid compounds such as N-phenyliminodiacetic acid, in an image forming layer of a planographic printing plate precursor or in a laser-decomposable resin composition. However, there is no description or suggestion for use of these compounds as a thermal base generator.

Accordingly, an object of the present invention is to provide a thermal base generator which is capable of performing cyclization of a thermosetting resin at a low temperature and with which a thermosetting resin composition having excellent stability can be prepared. Further, the present invention provides a thermosetting resin composition containing a thermal base generator, a cured film using the thermosetting resin composition, a cured film manufacturing method, and a semiconductor device.

As a result of extensive studies, the present inventors have found that an acidic compound which generates a base in a case of being heated to 40°C or higher, and an ammonium salt containing an anion having a pKa1 of 0 to 4 and an ammonium cation are capable of performing cyclization of a thermosetting resin at a low temperature, and can provide a thermosetting resin composition having excellent stability. The present invention has been completed based on such a finding. In particular, the present invention provides a thermal base generator, comprising
an acidic compound which is an ammonium salt containing a carboxylic acid anion having a pKa1 of 0-4 and an ammonium cation, wherein
(a) the carboxylic acid anion
   - is of the Formula EWG-C(=O)-O^{Θ} (X1), wherein EWG is an electron-withdrawing group selected from (EWG-1) to (EWG-6): 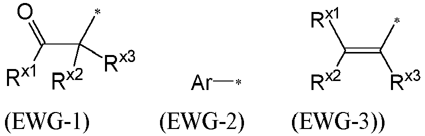 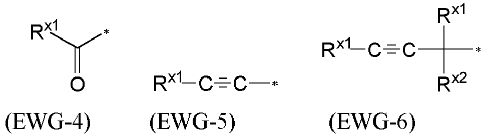 wherein R^{x1}-R^{x3} each independently are H, alkyl, alkenyl, aryl, hydroxyl or carboxyl, and Ar is an aromatic ring group; or
   - is a di- or higher-valent, preferably a divalent, anion of carboxylic acid having two or more carboxyl groups, more preferably an anion of the formula (X): 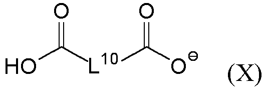 wherein L¹⁰ is a single bond, or a divalent linking group selected from alkylene, alkenylene, arylene, -NR^{X}- and a combination thereof, and R^{X} is H, alkyl, alkenyl or aryl,
      and particularly preferably is selected from a maleic acid anion, a phthalic acid anion, an N-phenyliminodiacetic acid anion and an oxalic acid anion; and
(b) the ammonium cation is one of the formulae (Y1-1) or (Y1-2): 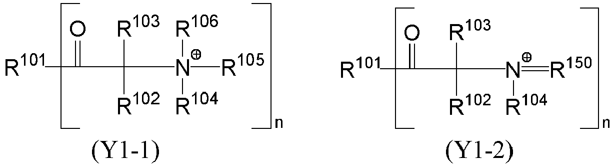 wherein
   - R¹⁰¹: is an n-valent organic group,
   - R¹⁰²-R¹⁰⁶: each independently are H or a hydrocarbon group,
   - R¹⁵⁰: is a hydrocarbon group, and R¹⁰⁴ and R¹⁰⁵, and R¹⁰⁴ and R¹⁵⁰ may be bonded to each other to form a ring, and
   - n: is an integer of ≥ 1,
   and preferably the ammonium cation is of the formula (Y1-1) or (Y1-2), more preferably of formula (Y1-1) or (Y1-2), wherein R¹⁰¹ is an aromatic ring group.

In addition, the invention provides a composition, which is a thermosetting resin composition comprising the thermal base generator and a thermosetting resin, as well as a cured film formed by curing the thermosetting resin composition.

The invention further provides a method for manufacturing a cured film, comprising applying the thermosetting resin composition onto a substrate; and curing the composition applied onto the substrate.

Furthermore, the invention provides a semiconductor device including the cured film formed by curing the thermosetting resin composition, or a cured film prepared by the method for manufacturing a cured film.

Preferred embodiments of the invention are as defined in the appended dependent claims and/or the following detailed description.

According to the present invention, it has now become possible to provide a thermal base generator which is capable of performing cyclization of a thermosetting resin at a low temperature and with which a thermosetting resin composition having excellent stability can be prepared. Further, it has also now become possible to provide a thermosetting resin composition containing a thermal base generator, a cured film using the thermosetting resin composition, a cured film manufacturing method, and a semiconductor device.

### BRIEF DESCRIPTION OF THE DRAWINGS

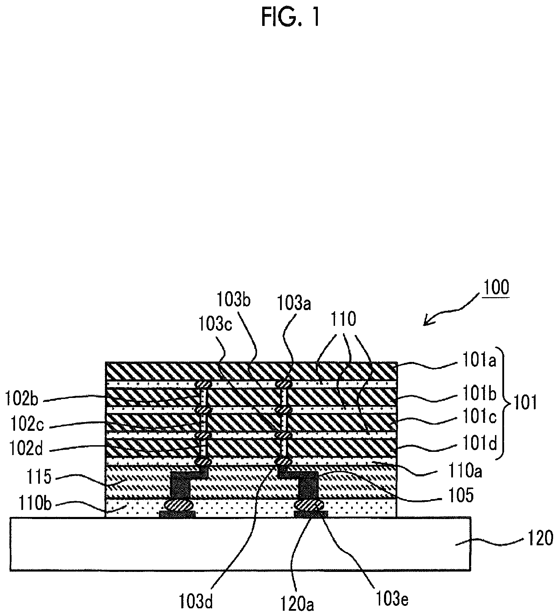

Fig. 1 is a schematic diagram showing a configuration of an embodiment of a semiconductor device.

### DESCRIPTION OF THE PREFERRED EMBODIMENTS

Description of the constitutive components in the present invention described below has been made on the basis of representative embodiments of the present invention, but the present invention is not limited to such embodiments.

Regarding the expression of "group (atomic group)" as used herein, the expression with no indication of "substituted" or "unsubstituted" includes both "substituted group" and "unsubstituted group". For example, "alkyl group" includes not only an alkyl group not having a substituent (unsubstituted alkyl group) but also an alkyl group having a substituent (substituted alkyl group).

As used herein, the term "actinic rays" means, for example, a bright line spectrum of a mercury lamp, far ultraviolet rays typified by excimer laser, extreme-ultraviolet rays (EUV light), X-rays or electron beams. The term "light" as used herein means actinic rays or radiations. Unless otherwise indicated, the "exposure" as used herein includes not only exposure to, e.g., a mercury lamp, far ultraviolet rays represented by excimer laser, X-rays or EUV light but also lithography with particle beams such as electron beams and ion beams.

As used herein, the numerical range expressed by using "to" means a range including the numerical values described before and after "to" as lower and upper limits.

As used herein, the term "(meth)acrylate" refers to both or any one of "acrylate" and "methacrylate"; the term "(meth)allyl" refers to both or any one of "allyl" and "methallyl"; the term "(meth)acrylic" refers to both or any one of "acrylic" and "methacrylic"; and the term "(meth)acryloyl" refers to both or any one of "acryloyl" and "methacryloyl".

The term "step" as used herein includes not only an independent step, but also a step which may not be clearly separated from another step, insofar as an expected effect of the step can be attained.

As used herein, the term "concentration of solid contents" refers to a mass percentage of the mass of other components except for a solvent, with respect to the total mass of the composition. Further, the concentration of solid contents is a concentration at 25°C, unless otherwise stated.

As used herein, the "weight-average molecular weight" is defined as a polystyrene-conversion value by GPC measurement. As used herein, the weight-average molecular weight (Mw) and number-average molecular weight (Mn) can be determined, for example, using HLC-8220 (manufactured by Tosoh Corporation), and TSKgel Super AWM-H (manufactured by Tosoh Corporation, 6.0 mmID×15.0 cm) as a column. Unless otherwise stated, it shall be measured using a 10 mmol/L lithium bromide N-methylpyrrolidinone (NMP) solution as an eluent.

### <Thermal base generator>

The thermal base generator of the present invention contains an acidic compound which is an ammonium salt containing a carboxylic acid anion having a pKa1 of 0 to 4 and an ammonium cation as described in the following.

Since the acidic compound generates a base upon heating, cyclization reaction of a thermosetting resin can be promoted by the action of a base generated from these compounds, and therefore cyclization of a thermosetting resin can be performed at a low temperature. In addition, since even in a case where these compounds are present together with a thermosetting resin which is cyclized to be cured by the action of a base, cyclization of the thermosetting resin hardly proceeds without heating, it is possible to prepare a thermosetting resin composition having excellent stability.

As used herein, the term "acidic compound" refers to a compound having a pH value of less than 7 measured at 20°C using a pH meter, by such a manner that 1 g of a compound is collected in a container, 50 mL of a mixed liquid of ion exchange water and tetrahydrofuran (mass ratio: water/tetrahydrofuran=1/4) is added thereto, followed by stirring at room temperature for 1 hour, and a pH value of the resulting solution is measured.

In the present invention, the base generation temperature of the acidic compound is preferably 40°C or higher, and more preferably 120°C to 200°C. The upper limit of the base generation temperature is preferably 190°C or lower, more preferably 180°C or lower, and still more preferably 165°C or lower. The lower limit of the base generation temperature is preferably 130°C or higher, and more preferably 135°C or higher.

If the base generation temperature of the acidic compound is 120°C or higher, the base is so unlikely to occur during preservation, and therefore it is possible to prepare a thermosetting resin composition having excellent stability. If the base generation temperature of the acidic compound is 200°C or lower, it is possible to decrease the temperature for cyclization of a thermosetting resin. The base generation temperature may be measured, for example, by heating a compound to 250°C at a rate of 5°C/minute in a pressure-resistant capsule, reading a peak temperature of an exothermic peak having the lowest temperature, and taking the peak temperature as a base generation temperature, using differential scanning calorimetry.

In the present invention, the base generated by a thermal base generator is preferably a secondary amine or a tertiary amine, and more preferably a tertiary amine. Since the tertiary amine has high basicity, the temperature for cyclization of a thermosetting resin can be further decreased. In addition, the boiling point of the base generated by a thermal base generator is preferably 80°C or higher, more preferably 100°C or higher, and most preferably 140°C or higher. The molecular weight of the base generated is preferably 80 to 2000. The lower limit is more preferably 100 or more. The upper limit is more preferably 500 or less. The value of the molecular weight is a theoretical value calculated from the structural formula.

In the present invention, the acidic compound is an ammonium salt containing a carboxylic acid anion having a pKa1 of 0-4 and an ammonium cation as described hereinafter.

Hereinafter, the thermal base generator will be described in more detail.

### «Ammonium salt»

In the present invention, the ammonium salt has an anion having a pKa1 of 0 to 4 and an ammonium cation. The upper limit of pKa1 of the anion is preferably 3.5 or less, and more preferably 3.2 or less. The lower limit is preferably 0.5 or more, and more preferably 1.0 or more. If a pKa1 of the anion is within the above-specified range, a thermosetting resin can be cyclized at a low temperature and further, stability of a thermosetting resin composition can be improved. If the pKa1 is 4 or less, stability of a thermal base generator is good and a base being generated without heating can be suppressed, so stability of a thermosetting resin composition is good. If the pKa1 is 0 or more, the generated base is hardly neutralized and cyclization efficiency of a thermosetting resin is satisfactory.

The anion is a carboxylic acid anion because it is possible for stability and thermal decomposition of a salt to be compatible. That is, the ammonium salt is a salt of an ammonium cation with a carboxylic acid anion.

The carboxylic acid anion is a divalent or higher-valent anion of carboxylic acid having two or more carboxyl groups, and preferably a divalent anion of carboxylic acid, more preferably of the formula (X).

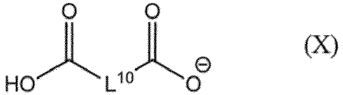

In General Formula (X), L¹⁰ represents a single bond, or a divalent linking group selected from an alkylene group, an alkenylene group, an arylene group, -NR^{X}-, and a combination thereof, and R^{X} represents a hydrogen atom, an alkyl group, an alkenyl group, or an aryl group.

The number of carbon atoms in the alkylene group represented by L¹⁰ is preferably 1 to 30, more preferably 1 to 20, and still more preferably 1 to 10. The alkylene group may be linear, branched, or cyclic, and is preferably linear or branched and more preferably linear. The alkylene group may have a substituent or may be unsubstituted. Examples of the substituent include those described for the substituent which may be contained in an organic group represented by A¹ to be described hereinafter.

The number of carbon atoms in the alkenylene group represented by L¹⁰ is preferably 2 to 30, more preferably 2 to 20, and still more preferably 2 to 10. The alkenylene group may be linear, branched, or cyclic, and is preferably linear or branched and more preferably linear. The alkenylene group may have a substituent or may be unsubstituted. Examples of the substituent include those described for the substituent which may be contained in an organic group represented by A¹ to be described hereinafter.

The number of carbon atoms in the arylene group represented by L¹⁰ is preferably 6 to 30, more preferably 6 to 20, and still more preferably 6 to 12. The arylene group may have a substituent or may be unsubstituted. Examples of the substituent include those described for the substituent which may be contained in an organic group represented by A¹ to be described hereinafter.

The number of carbon atoms in the alkyl group represented by R^{X} is preferably 1 to 30, more preferably 1 to 20, and still more preferably 1 to 10. The alkyl group may be linear, branched, or cyclic, and is preferably linear or branched and more preferably linear. The alkyl group may have a substituent or may be unsubstituted. Examples of the substituent include those described for the substituent which may be contained in an organic group represented by A¹ to be described hereinafter.

The number of carbon atoms in the alkenyl group represented by R^{X} is preferably 2 to 30, more preferably 2 to 20, and still more preferably 2 to 10. The alkenyl group may be linear, branched, or cyclic, and is preferably linear or branched and more preferably linear. The alkenyl group may have a substituent or may be unsubstituted. Examples of the substituent include those described for the substituent which may be contained in an organic group represented by A¹ to be described hereinafter.

The number of carbon atoms in the aryl group represented by R^{X} is preferably 6 to 30, more preferably 6 to 20, and still more preferably 6 to 12. The aryl group may have a substituent or may be unsubstituted. Examples of the substituent include those described for the substituent which may be contained in an organic group represented by A¹ to be described hereinafter.

Specific examples of the carboxylic acid anion include a maleic acid anion, a phthalic acid anion, an N-phenyliminodiacetic acid anion, and an oxalic acid anion. These anions may be preferably used.

According to this aspect, it is possible to obtain a thermal base generator capable of further improving stability, curability and developability of a thermosetting resin composition. In particular, the stability, curability, and developability of a thermosetting resin composition can be further improved by using a divalent anion of carboxylic acid.

In the present invention, the carboxylic acid anion is preferably an anion of carboxylic acid having a pKa1 of 3.5 or less, and more preferably 3.2 or less. According to this aspect, the stability of a thermosetting resin composition can be further improved.

Here, the pKa1 represents the logarithm of a reciprocal number of a first dissociation constant of an acid, and it is possible to refer to the values described in Determination of Organic Structures by Physical Methods (written by Brown, H. C., McDaniel, D. H., Hafliger, O., Nachod, F. C.; edited by Braude, E. A., Nachod, F. C.; Academic Press, New York, 1955), or Data for Biochemical Research (written by Dawson, R. M. C. et al.; Oxford, Clarendon Press, 1959). For compounds not listed in these documents, the value calculated from the structural formula using the software ACD/pKa (manufactured by ACD/Labs) shall be used.

Alternatively, in the present invention, the carboxylic acid anion is represented by the following Formula (X1). 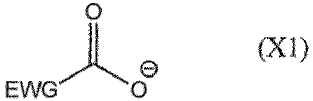 wherein EWG represents an electron-withdrawing groupselected from (EWG-1) to (EWG-6).

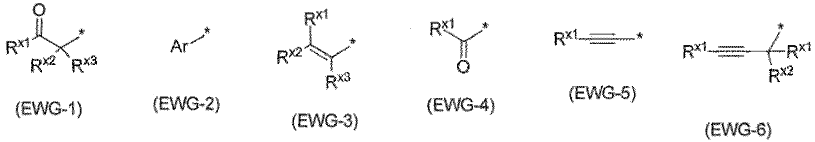

In the formula, R^{x1} to R^{x3} each independently represent a hydrogen atom, an alkyl group, an alkenyl group, an aryl group, a hydroxyl group, or a carboxyl group, and Ar represents an aromatic ring group.

The number of carbon atoms in the alkyl group is preferably 1 to 30, more preferably 1 to 20, and still more preferably 1 to 10. The alkyl group may be linear, branched, or cyclic, and is preferably linear or branched and more preferably linear. The alkyl group may have a substituent or may be unsubstituted. Examples of the substituent include those described for the substituent which may be contained in an organic group represented by A¹ to be described hereinafter. The substituent is preferably a carboxyl group.

The number of carbon atoms in the alkenyl group is preferably 2 to 30, more preferably 2 to 20, and still more preferably 2 to 10. The alkenyl group may be linear, branched, or cyclic, and is preferably linear or branched and more preferably linear. The alkenyl group may have a substituent or may be unsubstituted. Examples of the substituent include those described for the substituent which may be contained in an organic group represented by A¹ to be described hereinafter. The substituent is preferably a carboxyl group.

The number of carbon atoms in the aryl group is preferably 6 to 30, more preferably 6 to 20, and still more preferably 6 to 12. The aryl group may have a substituent or may be unsubstituted. Examples of the substituent include those described for the substituent which may be contained in an organic group represented by A¹ to be described hereinafter. The substituent is preferably a carboxyl group.

Specific examples of the aromatic ring group include a substituted or unsubstituted benzene ring, a naphthalene ring, a pentalene ring, an indene ring, an azulene ring, a heptalene ring, an indecene ring, a perylene ring, a pentacene ring, an acenaphthalene ring, a phenanthrene ring, an anthracene ring, a naphthacene ring, a chrysene ring, a triphenylene ring, a fluorene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring, and a phenazine ring. Among them, from the viewpoint of preservation stability and high sensitivity, preferred is a benzene ring, a naphthalene ring, an anthracene ring, a phenothiazine ring, or a carbazole ring, and more preferred is a benzene ring or a naphthalene ring.

Examples of the substituent which may be contained in the aromatic ring group include those described for the substituent which may be contained in an organic group represented by A¹ to be described hereinafter. The substituent is preferably a carboxyl group.

The ammonium cation is represented by one of the following Formulae (Y1-1) or (Y1-2).

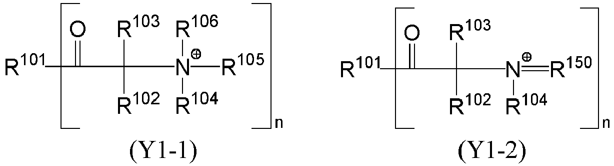

In the above-mentioned general formulae, R¹⁰¹ represents an n-valent organic group,
R¹⁰² to R¹⁰⁶ each independently represent a hydrogen atom, or a hydrocarbon group,
R¹⁵⁰ represents a hydrocarbon group,
R¹⁰⁴ and R¹⁰⁵, and R¹⁰⁴ and R¹⁵⁰ may be bonded to each other to form a ring, and
n represents an integer of 1 or more.

R¹⁰¹ represents an n-valent organic group. Examples of the monovalent organic group include an alkyl group, an alkylene group, and an aromatic ring group. Examples of the divalent or higher-valent organic group include n-valent groups obtained by removing one or more hydrogen atoms from a monovalent organic group to render n-valent.

R¹⁰¹ is preferably an aromatic ring group. Specific examples of the aromatic ring group include those described in Ar¹⁰ to be described hereinafter.

R¹⁰² to R¹⁰⁶ each independently represent a hydrogen atom, or a hydrocarbon group, and R¹⁵⁰ and R¹⁵¹ each independently represent a hydrocarbon group.

The hydrocarbon group represented by R¹⁰² to R¹⁰⁶, R¹⁵⁰ and R¹⁵¹ is preferably an alkyl group, an alkenyl group, or an aryl group. The alkyl group, alkenyl group, and aryl group may further have a substituent. Examples of the substituent include those described for the substituent which may be contained in an organic group represented by A¹ to be described hereinafter.

The number of carbon atoms in the alkyl group is preferably 1 to 30, more preferably 1 to 20, and still more preferably 1 to 10. The alkyl group may be linear, branched, or cyclic, and is preferably linear or branched and more preferably linear. The alkyl group may have a substituent or may be unsubstituted.

The number of carbon atoms in the alkenyl group is preferably 2 to 30, more preferably 2 to 20, and still more preferably 2 to 10. The alkenyl group may be linear, branched, or cyclic, and is preferably linear or branched and more preferably linear. The alkenyl group may have a substituent or may be unsubstituted.

The number of carbon atoms in the aryl group is preferably 6 to 30, more preferably 6 to 20, and still more preferably 6 to 12. The aryl group may have a substituent or may be unsubstituted.

R¹⁰⁴ and R¹⁰⁵, and R¹⁰⁴ and R¹⁵⁰, may be bonded to each other to form a ring. Examples of the ring include an alicyclic ring (non-aromatic hydrocarbon ring), an aromatic ring, and a heterocyclic ring. The ring may be monocyclic or polycyclic. Examples of the linking group in a case where the above-mentioned groups are bonded to each other to form a ring include divalent linking groups selected from the group consisting of -CO-, -O-, -NH-, a divalent aliphatic group, a divalent aromatic ring group, and a combination thereof. Specific examples of the ring include a pyrrolidine ring, a pyrrole ring, a piperidine ring, a pyridine ring, an imidazole ring, a pyrazole ring, an oxazole ring, a thiazole ring, a pyrazine ring, a morpholine ring, a thiazine ring, an indole ring, an isoindole ring, a benzimidazole ring, a purine ring, a quinoline ring, an isoquinoline ring, a quinoxaline ring, a cinnoline ring, and a carbazole ring.

In the present invention, the ammonium cation is preferably a structure which is represented by Formula (Y1-1) or (Y1-2) and in which R¹⁰¹ is an aromatic ring group, and more preferably a structure which is represented by Formula (Y1-1) and in which R¹⁰¹ is an aromatic ring group. That is, in the present invention, the ammonium cation is more preferably represented by the following General Formula (Y).

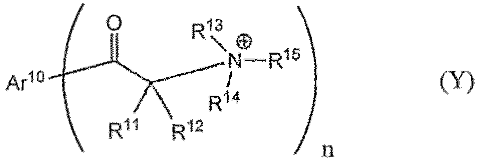

In General Formula (Y), Ar¹⁰ represents an aromatic ring group, R¹¹ to R¹⁵ each independently represent a hydrogen atom or a hydrocarbon group, R¹⁴ and R¹⁵ may be bonded to each other to form a ring, and n represents an integer of 1 or more.

Ar¹⁰ represents an aromatic ring group. Specific examples of the aromatic ring group include a substituted or unsubstituted benzene ring, a naphthalene ring, a pentalene ring, an indene ring, an azulene ring, a heptalene ring, an indecene ring, a perylene ring, a pentacene ring, an acenaphthalene ring, a phenanthrene ring, an anthracene ring, a naphthacene ring, a chrysene ring, a triphenylene ring, a fluorene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring, and a phenazine ring. Among them, from the viewpoint of preservation stability and high sensitivity, preferred is a benzene ring, a naphthalene ring, an anthracene ring, a phenothiazine ring, or a carbazole ring, and most preferred is a benzene ring or a naphthalene ring.

Examples of the substituent which may be contained in the aromatic ring group include those described for the substituent which may be contained in an organic group represented by A¹ to be described hereinafter.

R¹¹ and R¹² each independently represent a hydrogen atom or a hydrocarbon group. The hydrocarbon group is not particularly limited, and is preferably an alkyl group, an alkenyl group, or an aryl group.

R¹¹ and R¹² are preferably a hydrogen atom.

The number of carbon atoms in the alkyl group is preferably 1 to 30, more preferably 1 to 20, and still more preferably 1 to 10. The alkyl group may be linear, branched, or cyclic.

Examples of the linear or branched alkyl group include a methyl group, an ethyl group, a propyl group, a butyl group, a pentyl group, a hexyl group, a heptyl group, an octyl group, a nonyl group, a decyl group, a dodecyl group, a tetradecyl group, an octadecyl group, an isopropyl group, an isobutyl group, a sec-butyl group, a t-butyl group, a 1-ethylpentyl group, and a 2-ethylhexyl group.

The cyclic alkyl group (cycloalkyl group) may be a monocyclic cycloalkyl group or a polycyclic cycloalkyl group. Examples of the monocyclic cycloalkyl group include a cyclopropyl group, a cyclobutyl group, a cyclopentyl group, a cyclohexyl group, a cycloheptyl group, and a cyclooctyl group. Examples of the polycyclic cycloalkyl group include an adamantyl group, a norbornyl group, a bornyl group, a camphenyl group, a decahydronaphthyl group, a tricyclodecanyl group, a tetracyclodecanyl group, a camphoroyl group, a dicyclohexyl group, and a pinenyl group. Among them, most preferred is a cyclohexyl group from the viewpoint of compatibility with high sensitivity.

The number of carbon atoms in the alkenyl group is preferably 2 to 30, more preferably 2 to 20, and still more preferably 2 to 10. The alkenyl group may be linear, branched, or cyclic, and is preferably linear or branched and more preferably linear.

The number of carbon atoms in the aryl group is preferably 6 to 30, more preferably 6 to 20, and still more preferably 6 to 12.

R¹³ to R¹⁵ represent a hydrogen atom or a hydrocarbon group.

Examples of the hydrocarbon group include hydrocarbon groups described in the above-mentioned R¹¹ and R¹². R¹³ to R¹⁵ are particularly preferably an alkyl group, and preferred aspects thereof are also the same as those described in R¹¹ and R¹².

R¹⁴ and R¹⁵ may be bonded to each other to form a ring. Examples of the ring include an alicyclic ring (non-aromatic hydrocarbon ring), an aromatic ring, and a heterocyclic ring. The ring may be monocyclic or polycyclic. Examples of the linking group in a case where R⁴ and R⁵ are bonded to each other to form a ring include divalent linking groups selected from the group consisting of -CO-, -O-, -NH-, a divalent aliphatic group, a divalent aromatic ring group, and a combination thereof. Specific examples of the ring include a pyrrolidine ring, a pyrrole ring, a piperidine ring, a pyridine ring, an imidazole ring, a pyrazole ring, an oxazole ring, a thiazole ring, a pyrazine ring, a morpholine ring, a thiazine ring, an indole ring, an isoindole ring, a benzimidazole ring, a purine ring, a quinoline ring, an isoquinoline ring, a quinoxaline ring, a cinnoline ring, and a carbazole ring.

R¹³ to R¹⁵ is a linear alkyl group in which R¹⁴ and R¹⁵ may be bonded to each other to form a ring, or R¹³ contains 5 to 30 carbon atoms (more preferably 6 to 18 carbon atoms), and preferably an alkyl group in which R¹⁴ and R¹⁵ each independently contains 1 to 3 carbon atoms (more preferably 1 or 2 carbon atoms). According to this aspect, it is possible to easily generate amine species having a high boiling point.

In addition, with respect to R¹³ to R¹⁵, from the viewpoint of the basicity and boiling point of the amine species generated, the total number of carbon atoms of R¹³, R¹⁴ and R¹⁵ is preferably 7 to 30, and more preferably 10 to 20.

Further, due to the reason that it is easy to generate amine species having a high boiling point, the chemical formula weight of "-NR¹³R¹⁴R¹⁵" in General Formula (Y) is preferably 80 to 2000, and more preferably 100 to 500.

In General Formula (Y), n represents an integer of 1 or more, and is preferably 1 to 3 and more preferably 1 or 2, and particularly preferably 1. In a case where n is 2 or more, plural R¹¹'s to R¹⁵'s may be respectively the same or different.

Meanwhile, an embodiment for further improving adhesiveness to a copper wiring may be a form where, in General Formula (Y), R¹³ and R¹⁴ are a methyl group or an ethyl group, and R¹⁵ is a linear, branched or cyclic alkyl group having 5 or more carbon atoms, or an aromatic group. In this embodiment, preferred is that R¹³ and R¹⁴ are a methyl group, and R¹⁵ is a linear alkyl group having 5 to 20 carbon atoms, a branched alkyl group having 6 to 17 carbon atoms, a cyclic alkyl group having 6 to 10 carbon atoms, or a phenyl group, and more preferred is that R¹³ and R¹⁴ are a methyl group, and R¹⁵ is a linear alkyl group having 5 to 10 carbon atoms, a branched alkyl group having 6 to 10 carbon atoms, a cyclic alkyl group having 6 to 8 carbon atoms, or a phenyl group. By thus reducing hydrophobicity of the amine species, it is possible to more effectively suppress the lowering of affinity between the copper surface and the polyimide even in a case where the amine is deposited on the copper wiring. In this embodiment, preferred ranges of Ar¹⁰, R¹¹, R¹² and n are the same as described above.

Hereinafter, specific examples of the thermal base generator of the present invention are described, but the present invention is not limited thereto. These thermal base generators may be used alone or in combination of two or more thereof. Me in the following formulae represents a methyl group. Among the compounds shown below, (A-1) to (A-11) are reference examples which are not within the scope of the present claims. Among the compounds shown below, preferred are (A-18) to (A-26), and still more preferred are (A-18) to (A-21), (A-23), and (A-24).

From the viewpoint of improving the adhesiveness to copper, more preferred are (A-18) to (A-26), and (A-38) to (A-42), and still more preferred are (A-26) and (A-38) to (A-42).

**[Table 1]**

| Structure | Base generation temperature |
|---|---|
| 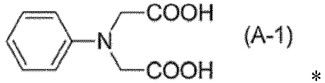 | 145°C |
| 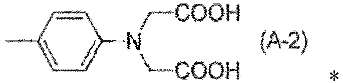 | 140°C |
| 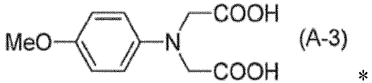 | 140°C |
| 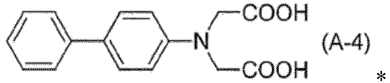 | 150°C |
| 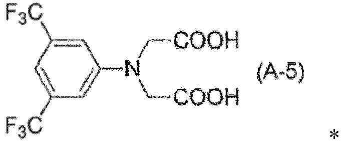 | 155°C |
| 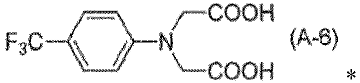 | 155°C |
| 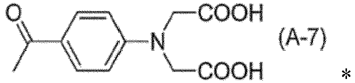 | 155°C |
| 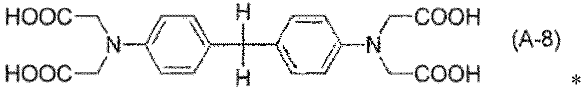 | 145°C |
| 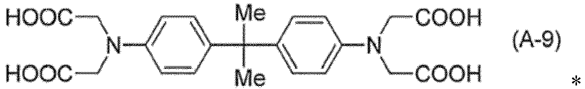 | 140°C |
| 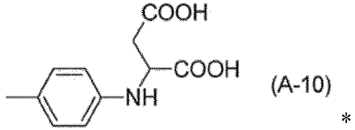 | 200°C |
| 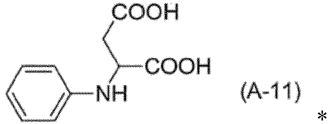 | 200°C |

| | |
|---|---|
| ^{∗}Reference Examples that are not within the scope of the present claims. | |

**[Table 2]**

| Structure | Base generation temperature |
|---|---|
| 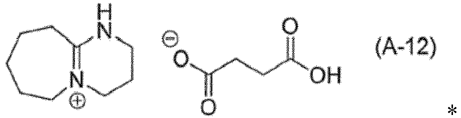 | 150°C |
| 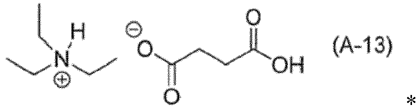 | 170°C |
| 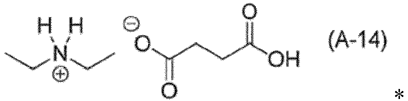 | 170°C |
| 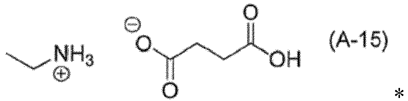 | 170°C |
| 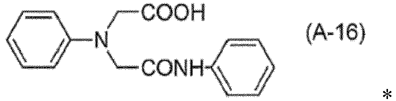 | 130°C |
| 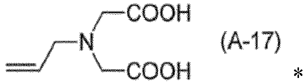 | 190°C |

| | |
|---|---|
| ^{∗}Reference Examples that are not within the scope of the present claims. | |

**[Table 3]**

| Structure | Base generation temperature pKa1 of anion |
|---|---|
| 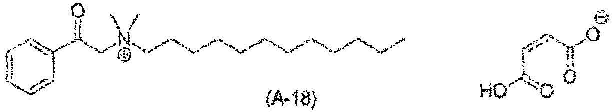 | Base generation temperature = 150°C pKa1 = 1.9 |
| 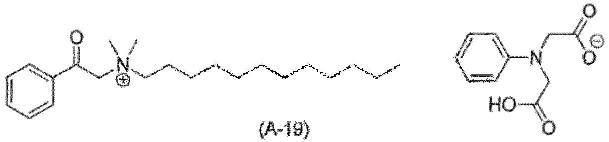 | Base generation temperature = 150°C pKa1 = 2.0 |
| 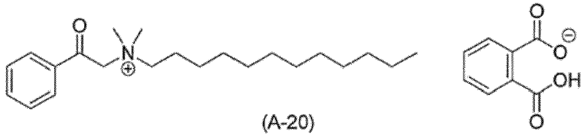 | Base generation temperature = 150°C pKa1 = 3.0 |
| 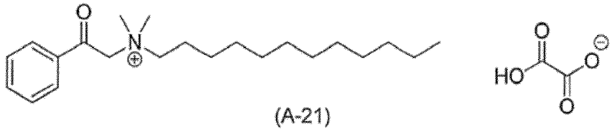 | Base generation temperature = 150°C pKa1 = 1.2 |
| 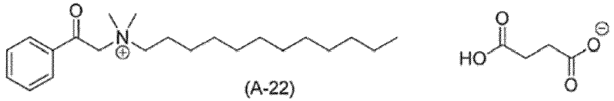 | Base generation temperature = 130°C pKa1 = 4.2 |
| 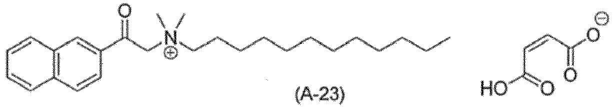 | Base generation temperature = 140°C pKa1 = 1.9 |
| 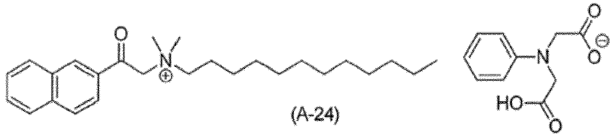 | Base generation temperature = 140°C pKa1 = 2.0 |
| 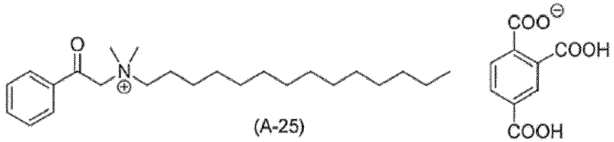 | Base generation temperature = 150°C pKa1 = 3.0 or less |
| 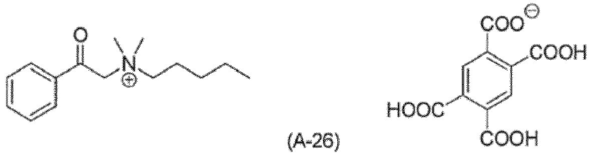 | Base generation temperature = 150°C pKa1 = 3.0 or less |

**[Table 4]**

| Structure | Base generation temperature pKa1 of anion |
|---|---|
| 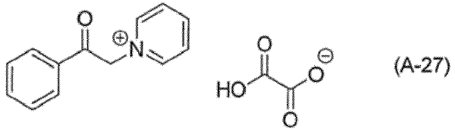 | Base generation temperature = 140°C pKa1 = 1.2 |
| 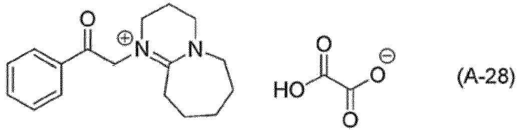 | Base generation temperature = 140°C pKa1 = 1.2 |
| 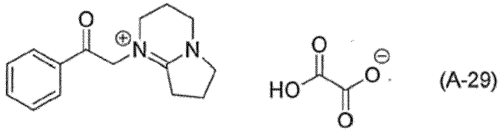 | Base generation temperature = 140°C pKa1 = 1.2 |
| 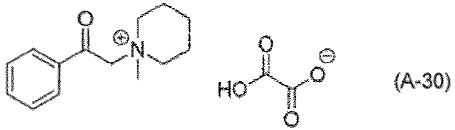 | Base generation temperature = 140°C pKa1 = 1.2 |
| 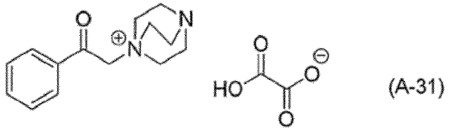 | Base generation temperature = 140°C pKa1 = 1.2 |
| 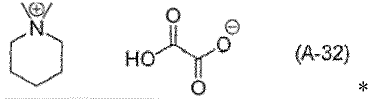 | Base generation temperature = 190°C pKa1 = 1.2 |
| 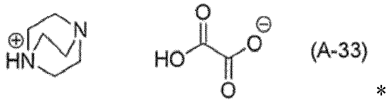 | Base generation temperature = 70°C pKa1 = 1.2 |
| 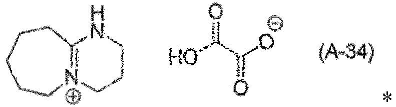 | Base generation temperature = 80°C pKa1 = 1.2 |
| 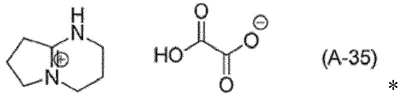 | Base generation temperature = 80°C pKa1 = 1.2 |
| 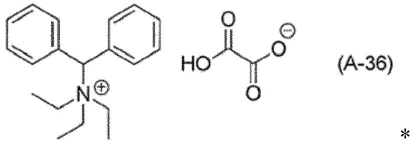 | Base generation temperature = 170°C pKa1 = 1.2 |
| 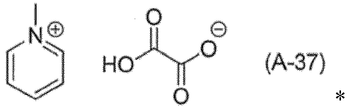 | Base generation temperature = 180°C pKa1 = 1.2 |

| | |
|---|---|
| ^{∗}Reference examples that are not within the scope of the claims. | |

**[Table 5]**

| Structure | Base generation temperature pKa1 of anion |
|---|---|
| 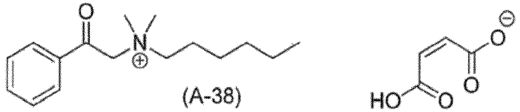 | Base generation temperature = 150°C pKa1 = 1.9 |
| 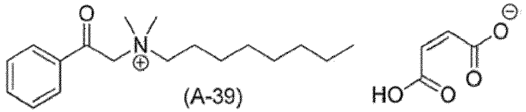 | Base generation temperature = 150°C pKa1 = 1.9 |
| 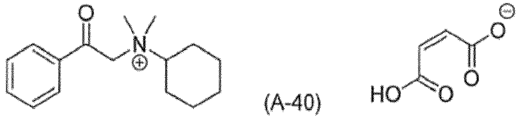 | Base generation temperature = 150°C pKa1 = 1.9 |
| 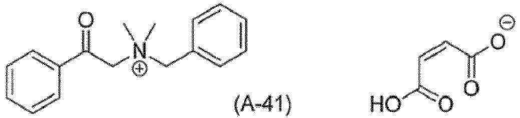 | Base generation temperature = 150°C pKa1 = 1.9 |
| 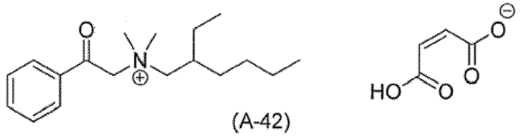 | Base generation temperature = 150°C pKa1 = 1.9 |

### <Thermosetting resin composition>

Next, the thermosetting resin composition of the present invention will be described.

The thermosetting resin composition of the present invention contains the above-mentioned thermal base generator and a thermosetting resin. The thermosetting resin is preferably a thermosetting resin which is cyclized by the action of a base, thereby curing thereof being promoted.

By using this thermosetting resin composition, it is possible to carry out cyclization reaction of a thermosetting resin at a low temperature, and it is possible to achieve a thermosetting resin composition having excellent stability. In addition, since the thermal base generator of the present invention does not generate a base without heating, it is possible to suppress cyclization of a thermosetting resin during preservation even in a case where the thermal base generator of the present invention is present together with the thermosetting resin, whereby preservation stability is excellent.

In the thermosetting resin composition of the present invention, the thermal base generator is preferably an acidic compound composed of the above-mentioned ammonium salt. The preferred range of the ammonium salt is the same as the range described in the thermal base generator.

The content of the thermal base generator in the thermosetting resin composition is preferably 0.1 to 50 mass% with respect to the total solid content of the thermosetting resin composition. The lower limit is more preferably 0.5 mass% or more, and still more preferably 1 mass% or more. The upper limit is more preferably 30 mass% or less, and still more preferably 20 mass% or less. Further, with respect to 100 parts by mass of the thermosetting resin, the thermal base generator is contained in an amount of preferably 0.1 to 30 parts by mass, and more preferably 1 to 20 parts by mass. If the content of the thermal base generator is within the above-specified range, it is possible to carry out cyclization of the thermosetting resin at a low temperature, and it is possible to form a cured film having excellent heat resistance by heat treatment at a low temperature.

The thermal base generators may be used alone or in combination of two or more thereof. In a case of using two or more thermal base generators, it is preferred that the total amount thereof is within the above-specified range.

### <<Thermosetting resin>>

Any of thermosetting resins may be preferably used as long as it is cyclized by the action of a base, whereby the curing thereof is accelerated. Among them, preferred is a heterocyclic ring-containing polymer precursor resin capable of forming a heterocyclic ring-containing polymer through occurrence of a cyclization reaction by heating. The heterocyclic ring-containing polymer precursor resin is preferably one or more selected from a polyimide precursor resin, a polyamideimide precursor resin, and a polybenzoxazole precursor resin, more preferably a polyimide precursor resin or a polybenzoxazole precursor resin, and still more preferably a polyimide precursor resin. According to this aspect, it is easy to form a cured film having superior heat resistance. Further, these thermosetting resins have a high cyclization temperature and therefore have been conventionally subjected to cyclization by heating to 300°C or higher, but according to the present invention, even for these thermosetting resins, the cyclization reaction can be sufficiently proceeded by heating at 300°C or lower (preferably 200°C or lower, and still more preferably 180°C or lower).

In the present invention, a thermosetting resin is preferably one having an ethylenically unsaturated bond, and more preferably a polyimide precursor resin having an ethylenically unsaturated bond. Due to the point that the thermosetting resin has an ethylenically unsaturated bond, it is easy to form a cured film having superior heat resistance. Further, in the case of performing patterning by photolithography, it is possible to increase the sensitivity.

The content of the thermosetting resin in the thermosetting resin composition is preferably 30 to 90 mass% with respect to the total solid content of the thermosetting resin composition. The lower limit is more preferably 40 mass% or more, and still more preferably 50 mass% or more.

### <<<Polyimide precursor resin and polyamideimide precursor resin>>>

The polyimide precursor resin is not particularly limited as long as it is a compound capable of being made into polyimide, and is preferably a polyimide precursor resin having an ethylenically unsaturated bond.

Further, the polyamideimide precursor resin is not particularly limited as long as it is a compound capable of being made into polyamideimide, and is preferably a polyamideimide precursor resin having an ethylenically unsaturated bond.

The polyimide precursor resin and the polyamideimide precursor resin are most preferably a compound containing a repeating unit represented by the following General Formula (2).

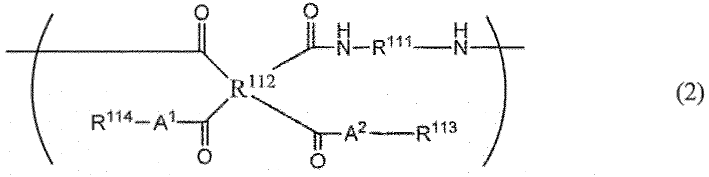

In General Formula (2), A¹ and A² each independently represent an oxygen atom or -NH-, R¹¹¹ represents a divalent organic group, R¹¹² represents a tetravalent organic group, and R¹¹³ and R¹¹⁴ each independently represent a hydrogen atom or a monovalent organic group.

A¹ and A² each independently represent an oxygen atom or -NH- and are preferably an oxygen atom.

R¹¹¹ represents a divalent organic group. Examples of the divalent organic group include diamine residues remaining after removal of amino groups of diamine. Examples of the diamine include an aliphatic diamine, a cycloaliphatic diamine, and an aromatic diamine.

Specific examples of the divalent organic group include diamine residues remaining after removal of amino groups of the following diamines.

Diamine residues remaining after removal of amino groups of at least one diamine selected from 1,2-diaminoethane, 1,2-diaminopropane, 1,3-diaminopropane, 1,4-diaminobutane, and 1,6-diaminohexane; 1,2- or 1,3-diaminocyclopentane, 1,2-, 1,3- or 1,4-diaminocyclohexane, 1,2-, 1,3- or 1,4-bis(aminomethyl)cyclohexane, bis-(4-aminocyclohexyl)methane, bis-(3-aminocyclohexyl)methane, 4,4'-diamino-3,3'-dimethylcyclohexylmethane and isophoronediamine; m- and p-phenylenediamine, diaminotoluene, 4,4'- and 3,3'-diaminobiphenyl, 4,4'- and 3,3'-diaminodiphenylether, 4,4'- and 3,3'-diaminodiphenylmethane, 4,4'- and 3,3'-diaminodiphenylsulfone, 4,4'- and 3,3'-diaminodiphenylsulfide, 4,4'- and 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 4,4'-diamino-p-terphenyl, 4,4'-bis(4-aminophenoxy)biphenyl, bis[4-(4-aminophenoxy)phenyl]sulfone, bis[4-(3 -aminophenoxy)phenyl] sulfone, bis[4-(2-aminophenoxy)phenyl] sulfone, 1,4-bis(4-aminophenoxy)benzene, 9,10-bis(4-aminophenyl)anthracene, 3,3'-dimethyl-4,4'-diaminodiphenylsulfone, 1,3-bis(4-aminophenoxy)benzene, 1,3-bis(3-aminophenoxy)benzene, 1,3-bis(4-aminophenyl)benzene, bis[4-(4-aminophenoxy)phenyl]ether, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 2,2-bis(4-aminophenyl)hexafluoropropane, 9,9-bis(4-aminophenyl)-10-hydroanthracene, 3,3',4,4'-tetraaminobiphenyl, 3,3',4,4'-tetraaminodiphenylether, 1,4-diaminoanthraquinone, 1,5-diaminoanthraquinone, bis[4-(4-aminophenoxy)phenyl]sulfone, bis[4-(3-aminophenoxy)phenyl]sulfone, bis[4-(2-aminophenoxy)phenyl]sulfone, 3,3-dihydroxy-4,4'-diaminobiphenyl, 9,9'-bis(4-aminophenyl)fluorene, 4,4' -dimethyl-3,3' -diaminodiphenylsulfone, 3,3',5,5'-tetramethyl-4,4'-diaminodiphenylmethane, 2,4- and 2,5-diaminocumene, 2,5-dimethyl-p-phenylenediamine, acetoguanamine, 2,3,5,6-tetramethyl-p-phenylenediamine, 2,4,6-trimethyl-m-phenylenediamine, bis(3-aminopropyl)tetramethyldisiloxane, 2,7-diaminofluorene, 2,5-diaminopyridine, 1,2-bis(4-aminophenyl)ethane, diaminobenzanilide, ester of diaminobenzoic acid, 1,5-diaminonaphthalene, diaminobenzotrifluoride, diaminoanthraquinone, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis[4-(4-aminophenoxy)-3,5-bis(trifluoromethyl)phenyl]hexafluoropropane, p-bis(4-amino-2-trifluoromethylphenoxy)benzene, 4,4' -bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenylsulfone, 4,4'-bis(3-amino-5-trifluoromethylphenoxy)diphenylsulfone, 2,2-bis[4-(4-amino-3-trifluoromethylphenoxy)phenyl]hexafluoropropane, 3,3',5,5'-tetramethyl-4,4'-diaminobiphenyl, 3,3'-dimethoxy-4,4'-diaminobiphenyl, 2,2',5,5',6,6'-hexafluorotriden and 4,4‴diaminoquaterphenyl.

R¹¹² represents a tetravalent organic group. Examples of the tetravalent organic group include tetracarboxylic acid residues remaining after removal of anhydride groups from a tetracarboxylic dianhydride.

Specific examples of the tetravalent organic group include tetracarboxylic acid residues remaining after removal of anhydride groups from the following tetracarboxylic dianhydrides.

Tetracarboxylic acid residues remaining after removal of anhydride groups from at least one tetracarboxylic dianhydride selected from a pyromellitic dianhydride (PMDA), a 3,3',4,4'-biphenyltetracarboxylic dianhydride, a 3,3',4,4'-diphenylsulfidetetracarboxylic dianhydride, a 3,3',4,4'-diphenylsulfonetetracarboxylic dianhydride, a 3,3',4,4'-benzophenonetetracarboxylic dianhydride, a 3,3',4,4'-diphenylmethanetetracarboxylic dianhydride, a 2,2',3,3'-diphenylmethanetetracarboxylic dianhydride, a 2,3,3',4'-biphenyltetracarboxylic dianhydride, a 2,3,3',4'-benzophenonetetracarboxylic dianhydride, a dianhydride of oxydiphthalic acid, a 3,3',4,4'-diphenyloxidetetracarboxylic dianhydride, a 4,4'-oxydiphthalic dianhydride, a 2,3,6,7-naphthalenetetracarboxylic dianhydride, a 1,4,5,7-naphthalenetetracarboxylic dianhydride, a 2,2-bis(3,4-dicarboxyphenyl)propane dianhydride, a 2,2-bis(2,3-dicarboxyphenyl)propane dianhydride, a 2,2-bis(3,4-dicarboxyphenyl)hexafluoropropane dianhydride, a 1,3-diphenylhexafluoropropane-3,3,4,4-tetracarboxylic dianhydride, a 1,4,5,6-naphthalenetetracarboxylic dianhydride, a 2,2',3,3'-diphenyltetracarboxylic dianhydride, a 3,4,9,10-perylenetetracarboxylic dianhydride, a 1,2,4,5-naphthalenetetracarboxylic dianhydride, a 1,4,5,8-naphthalenetetracarboxylic dianhydride, a 1,8,9,10-phenanthrenetetracarboxylic dianhydride, a 1,1-bis(2,3-dicarboxyphenyl)ethane dianhydride, a 1,1-bis(3,4-dicarboxyphenyl)ethane dianhydride, a 1,2,3,4-benzenetetracarboxylic dianhydride, and C1-C6 alkyl and C1-C6 alkoxy derivatives thereof.

R¹¹³ and R¹¹⁴ each independently represent a hydrogen atom or a monovalent organic group.

As the monovalent organic group represented by R¹¹³ and R¹¹⁴, a substituent that improves the solubility of a developer is preferably used.

From the viewpoint of solubility in an aqueous developer, R¹¹³ and R¹¹⁴ are preferably a hydrogen atom or a monovalent organic group. Examples of the monovalent organic group include an aryl group and an aralkyl group, each having one, two, three, preferably one acidic group bonded to an aryl carbon. Specific examples of the monovalent organic group include an aryl group containing an acidic group and having 6 to 20 carbon atoms, and an aralkyl group containing an acidic group and having 7 to 25 carbon atoms. More specific examples thereof include a phenyl group containing an acidic group and a benzyl group containing an acidic group. The acidic group is preferably an HO group.

In a case where R¹¹³ and R¹¹⁴ are a hydrogen atom, 2-hydroxybenzyl, 3-hydroxybenzyl or 4-hydroxybenzyl, the solubility in an aqueous developer is favorable, and it is particularly suitably used as a negative tone thermosetting resin composition.

From the viewpoint of solubility in an organic solvent, R¹¹³ and R¹¹⁴ are preferably a monovalent organic group. The monovalent organic group is particularly preferably an alkyl group, a cycloalkyl group, or an aromatic ring group.

The number of carbon atoms in the alkyl group is preferably 1 to 30. The alkyl group may be linear, branched, or cyclic. Examples of the linear or branched alkyl group include a methyl group, an ethyl group, a propyl group, a butyl group, a pentyl group, a hexyl group, a heptyl group, an octyl group, a nonyl group, a decyl group, a dodecyl group, a tetradecyl group, an octadecyl group, an isopropyl group, an isobutyl group, a sec-butyl group, a t-butyl group, a 1-ethylpentyl group, and a 2-ethylhexyl group. The cyclic alkyl group (cycloalkyl group) may be a monocyclic cycloalkyl group or a polycyclic cycloalkyl group. Examples of the monocyclic cycloalkyl group include a cyclopropyl group, a cyclobutyl group, a cyclopentyl group, a cyclohexyl group, a cycloheptyl group, and a cyclooctyl group. Examples of the polycyclic cycloalkyl group include an adamantyl group, a norbornyl group, a bornyl group, a camphenyl group, a decahydronaphthyl group, a tricyclodecanyl group, a tetracyclodecanyl group, a camphoroyl group, a dicyclohexyl group, and a pinenyl group. Among them, a cyclohexyl group is most preferable from the viewpoint of compatibility with high sensitivity.

The aromatic ring group is specifically a substituted or unsubstituted benzene ring, a naphthalene ring, a pentalene ring, an indene ring, an azulene ring, a heptalene ring, an indecene ring, a perylene ring, a pentacene ring, an acenaphthalene ring, a phenanthrene ring, an anthracene ring, a naphthacene ring, a chrysene ring, a triphenylene ring, a fluorene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring or a phenazine ring. Most preferred is a benzene ring.

In General Formula (2), at least one of R¹¹³ or R¹¹⁴ preferably has a polymerizable group. Accordingly, sensitivity and resolution can be made better.

Examples of the polymerizable group contained in R¹¹³ and R¹¹⁴ include an epoxy group, an oxetanyl group, a group having an ethylenically unsaturated bond, a blocked isocyanate group, an alkoxymethyl group, a methylol group, and an amino group. Among them, a group having an ethylenically unsaturated bond is preferable due to sensitivity being good. Examples of the group having an ethylenically unsaturated bond include a vinyl group, a (meth)allyl group, and a group represented by the following Formula (III).

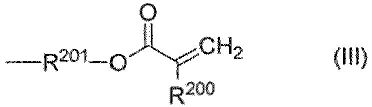

In Formula (III), R²⁰⁰ represents hydrogen or methyl, and is more preferably methyl. In Formula (III), R²⁰¹ represents an alkylene group having 2 to 12 carbon atoms, -CH₂CH(OH)CH₂- or a polyoxyalkylene group having 4 to 30 carbon atoms.

Suitable examples of R²⁰¹ include ethylene, propylene, trimethylene, tetramethylene, 1,2-butanediyl, 1,3-butanediyl, pentamethylene, hexamethylene, octamethylene, dodecamethylene, and -CH₂CH(OH)CH₂-. More preferred is ethylene, propylene, trimethylene, or -CH₂CH(OH)CH₂-.

Particularly preferably, R²⁰⁰ is methyl, and R²⁰¹ is ethylene.

With respect to the proportion of the polymerizable group contained in R¹¹³ and R¹¹⁴ in General Formula (2), the ratio of polymerizable group:non-polymerizable group is preferably 100:0 to 5:95, more preferably 100:0 to 20:80, and most preferably 100:0 to 50:50 in terms of molar ratio.

The polyimide precursor resin and the polyamideimide precursor resin may include, in addition to the above-mentioned repeating structural units of General Formula (2) all of which are based on one type of R¹¹¹ or R¹¹², repeating units based on two or more different types of these groups. Further, the polyimide precursor resin and the polyamideimide precursor resin may include repeating units that become structural isomers with respect to each other. Regarding the expression of structural isomer pairs of units of General Formula (2), for example, an example of a unit of Formula (2) in which R¹¹² is represented by a pyromellitic acid residue, derived from pyromellitic acid, is shown below (A¹ and A² = -O-).

Further, the polyimide precursor resin and the polyamideimide precursor resin may also include other types of repeating structural units, in addition to the above-mentioned repeating units of General Formula (2).

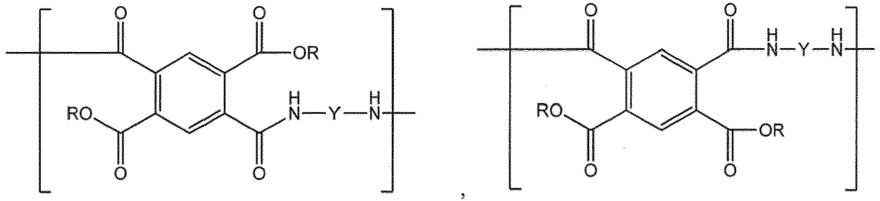

The weight-average molecular weight (Mw) of the polyimide precursor resin and the polyamideimide precursor resin is preferably 1,000 to 100,000, and more preferably 3,000 to 50,000, most preferably 5,000 to 30,000. The weight-average molecular weight (Mw) of the polyimide precursor resin and the polyamideimide precursor resin can be measured, for example, by gel permeation chromatography calibrated with polystyrene.

### <<<Polybenzoxazole precursor resin>>>

The polybenzoxazole precursor resin is not particularly limited as long as it is a compound capable of being made into polybenzoxazole, and is preferably a polybenzoxazole precursor resin having an ethylenically unsaturated bond. In particular, most preferred is a compound represented by the following General Formula (3). 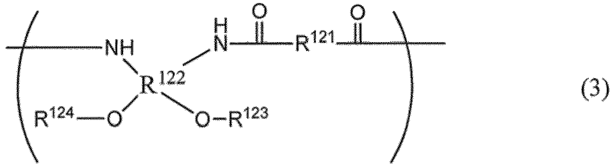 In General Formula (3), R¹²¹ represents a divalent organic group, R¹²² represents a tetravalent organic group, and R¹²³ and R¹²⁴ each independently represent a hydrogen atom or a monovalent organic group.

R¹²¹ represents a divalent organic group. The divalent organic group is preferably an aromatic ring group. Examples of the aromatic ring group include the following.

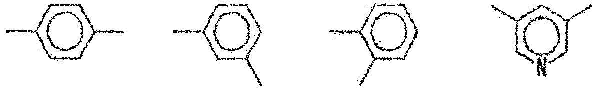

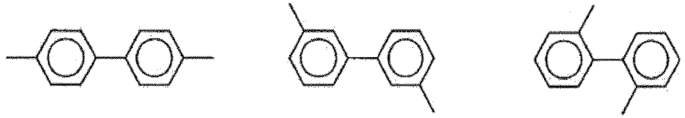

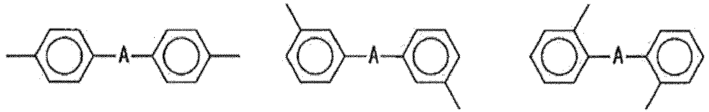

In the formula, A represents a divalent group selected from the group consisting of -CH₂-, -O-, -S-, -SO₂-, -CO-, -NHCO-, and -C(CF₃)₂-.

R¹²² represents a tetravalent organic group. The tetravalent organic group is preferably a residue of bisaminophenol represented by the following General Formula (A).

Ar(NH₂)₂(OH)₂ ··· (A)

In the formula, Ar is an aryl group.

Examples of the bisaminophenol of General Formula (A) include 3,3'-dihydroxybenzidine, 3,3'-diamino-4,4'-dihydroxybiphenyl, 4,4'-diamino-3,3'-dihydroxybiphenyl, 3,3'-diamino-4,4'-dihydroxydiphenylsulfone, 4,4'-diamino-3,3'-dihydroxydiphenylsulfone, bis-(3-amino-4-hydroxyphenyl)methane, 2,2-bis-(3-amino-4-hydroxyphenyl)propane, 2,2-bis-(3-amino-4-hydroxyphenyl)hexafluoropropane, 2,2-bis-(4-amino-3-hydroxyphenyl)hexafluoropropane, bis-(4-amino-3-hydroxyphenyl)methane, 2,2-bis-(4-amino-3-hydroxyphenyl)propane, 4,4'-diamino-3,3'-dihydroxybenzophenone, 3,3'-diamino-4,4'-dihydroxybenzophenone, 4,4' -diamino-3,3 '-dihydroxydiphenylether, 3,3' -diamino-4,4'-dihydroxydiphenylether, 1,4-diamino-2,5-dihydroxybenzene, 1,3-diamino-2,4-dihydroxybenzene, and 1,3-diamino-4,6-dihydroxybenzene. These bisaminophenols may be used alone or in combination thereof.

Among bisaminophenols represented by General Formula (A), particularly preferred is a bisaminophenol having an aromatic ring group selected from the following.

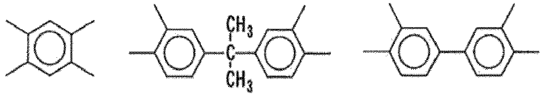

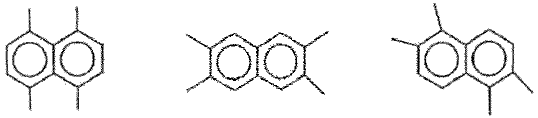

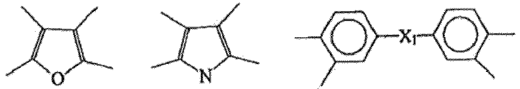

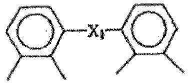

In the formulae, X₁ represents -O-, -S-, -C(CF₃)₂-, -CH₂-, -SO₂-, or -NHCO-. In the above structures, -OH and -NH₂ contained in the structure of General Formula (A) bind to an ortho position (adjacent position) to each other.

R¹²³ and R¹²⁴ represent a hydrogen atom or a monovalent organic group, and at least one of R¹²³ or R¹²⁴ preferably represents a polymerizable group. The polymerizable group is the same as in aspects described for R¹¹³ and R¹¹⁴ of the above-mentioned General Formula (2), and a preferred range thereof is also the same.

The polybenzoxazole precursor resin may also contain other types of repeating structural units, in addition to the repeating units of General Formula (3).

The weight-average molecular weight (Mw) of the polybenzoxazole precursor resin is preferably 1,000 to 100,000, more preferably 3,000 to 50,000, and particularly preferably 5,000 to 30,000. The weight-average molecular weight (Mw) of the polybenzoxazole precursor resin can be measured, for example, by gel permeation chromatography calibrated with polystyrene.

### «Polymerizable compound»

The thermosetting resin composition of the present invention may contain a thermal base generator and a polymerizable compound other than a thermosetting resin. By including a polymerizable compound, it is possible to form a cured film having superior heat resistance. Further, it is also possible to perform patterning by photolithography.

The polymerizable compound is a compound having a polymerizable group, and may be a known compound which is polymerizable by radicals. The polymerizable group is a group capable of polymerizing by the action of actinic rays, radiations or radicals, and examples thereof include a group having an ethylenically unsaturated bond. The group having an ethylenically unsaturated bond is preferably a styryl group, a vinyl group, a (meth)acryloyl group or a (meth)allyl group, and more preferably a (meth)acryloyl group. That is, the polymerizable compound used in the present invention is preferably a compound having an ethylenically unsaturated bond, more preferably a (meth)acrylate compound, and still more preferably an acrylate compound.

The polymerizable compounds are those which are widely known in the industrial field, and it is possible to use these compounds in the present invention without any particular limitation. These compounds may be in any of chemical forms, for example, a monomer, a prepolymer, an oligomer or a mixture thereof and a multimer thereof.

In the present invention, a polymerizable compound of a monomer type (hereinafter, also referred to as a polymerizable monomer) is a compound different from the polymer compound. The polymerizable monomer is typically a low-molecular weight compound, preferably a low-molecular weight compound having a molecular weight of 2000 or less, more preferably a low-molecular weight compound having a molecular weight of 1500 or less, and still more preferably a low-molecular weight compound having a molecular weight of 900 or less. Further, the molecular weight of the polymerizable monomer is usually 100 or more.

Further, a polymerizable compound of an oligomer type (hereinafter, also referred to as a polymerizable oligomer) is typically a polymer having a relatively low molecular weight, and preferably a polymer in which 10 to 100 polymerizable monomers are bonded. The molecular weight thereof is preferably 2000 to 20000, more preferably 2000 to 15000, and most preferably 2000 to 10000, in terms of polystyrene-converted weight-average molecular weight by a gel permeation chromatography (GPC) method.

The number of functional groups in a polymerizable compound in the present invention refers to the number of polymerizable groups in one molecule.

From the viewpoint of resolution, the polymerizable compound preferably contains at least one bifunctional or higher-functional polymerizable compound containing two or more polymerizable groups, and more preferably contains at least one trifunctional or higher-functional polymerizable compound.

From the viewpoint of being able to improve heat resistance through the formation of a three-dimensional crosslinked structure, the polymerizable compound in the present invention preferably contains at least one trifunctional or higher-functional polymerizable compound. Further, the polymerizable compound may be a mixture of a bifunctional or lower-functional polymerizable compound and a trifunctional or higher-functional polymerizable compound.

Specific examples of the polymerizable compound include an unsaturated carboxylic acid (for example, acrylic acid, methacrylic acid, itaconic acid, crotonic acid, isocrotonic acid or maleic acid), its esters and amides, and multimers thereof. Esters of an unsaturated carboxylic acid and a polyhydric alcohol compound, amides of an unsaturated carboxylic acid and a polyvalent amine compound, and multimers thereof are preferred. Also, addition reaction products of unsaturated carboxylic acid esters or amides having a nucleophilic substituent, for example, a hydroxyl group, an amino group or a mercapto group, with monofunctional or polyfunctional isocyanates or epoxy compounds, and dehydration condensation reaction products with a monofunctional or polyfunctional carboxylic acid are also suitably used. Further, addition reaction products of unsaturated carboxylic acid esters or amides having an electrophilic substituent, for example, an isocyanate group or an epoxy group, with monofunctional or polyfunctional alcohols, amines or thiols, and substitution reaction products of unsaturated carboxylic acid esters or amides having a leaving substituent, for example, a halogen group or a tosyloxy group, with monofunctional or polyfunctional alcohols, amines or thiols are also suitable. As other examples, a group of compounds where the unsaturated carboxylic acid described above is replaced by an unsaturated phosphonic acid, a vinylbenzene derivative, for example, styrene, vinyl ether, or allyl ether may also be used.

Specific examples of the monomer, which is an ester of a polyhydric alcohol compound with an unsaturated carboxylic acid, include, as an acrylic acid ester, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, dipentaerythritol diacrylate, dipentaerythritol hexaacrylate, pentaerythritol tetraacrylate, sorbitol triacrylate, sorbitol tetraacrylate, sorbitol pentaacrylate, sorbitol hexaacrylate, tri(acryloyloxyethyl)isocyanurate, isocyanuric acid ethylene oxide-modified triacrylate, and polyester acrylate oligomer.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, and bis-[p-(methacryloxyethoxy)phenyl]dimethylmethane.

Examples of the itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of the crotonic acid ester include ethylene glycol dicrotonate, tetramethylene glycol dicrotonate, pentaerythritol dicrotonate, and sorbitol tetradicrotonate.

Examples of the isocrotonic acid ester include ethylene glycol diisocrotonate, pentaerythritol diisocrotonate, and sorbitol tetraisocrotonate.

Examples of the maleic acid ester include ethylene glycol dimaleate, triethylene glycol dimaleate, pentaerythritol dimaleate, and sorbitol tetramaleate.

As other examples of the ester, for example, aliphatic alcohol esters described in JP1971-27926B (JP-S46-27926B), JP1976-47334B (JP-S51-47334B) and JP1982-196231A (JP-S57-196231A), esters having an aromatic skeleton described in JP1984-5240A (JP-S59-5240A), JP1984-5241A (JP-S59-5241A) and JP1990-226149A (JP-H2-226149A), and esters containing an amino group described in JP1989-165613A (JP-H1-165613A) are also preferably used.

Specific examples of the monomer, which is an amide of a polyvalent amine compound with an unsaturated carboxylic acid, include methylene bisacrylamide, methylene bismethacrylamide, 1,6-hexamethylene bis-acrylamide, 1,6-hexamethylene bis-methacrylamide, diethylenetriamine trisacrylamide, xylylene bisacrylamide, and xylylene bismethacrylamide.

Other preferred examples of the amide monomer include those having a cyclohexylene structure described in JP1979-21726B (JP-S54-21726B).

Urethane-based addition polymerizable compounds produced using an addition reaction between an isocyanate and a hydroxyl group are also suitable, and specific examples thereof include vinylurethane compounds having two or more polymerizable vinyl groups per molecule obtained by adding a vinyl monomer containing a hydroxyl group represented by General Formula (A) shown below to a polyisocyanate compound having two or more isocyanate groups per molecule, described in JP1973-41708B (JP-S48-41708B).

CH₂=C(R⁴)COOCH₂CH(R⁵)OH ··· (A)

(R⁴ and R⁵ represent H or CH₃)

Further, urethane acrylates as described in JP1976-37193A (JP-S51-37193A), JP1990-32293B (JP-H2-32293B) and JP1990-16765B (JP-H2-16765B), and urethane compounds having an ethylene oxide skeleton as described in JP1983-49860B (JP-S58-49860B), JP1981-17654B (JP-S56-17654B), JP1987-39417B (JP-S62-39417B), and JP1987-39418B (JP-S62-39418B) are also suitable.

Also, as the polymerizable compound, compounds described in paragraphs "0095" to "0108" of JP2009-288705A may be suitably used also in the present invention.

The polymerizable compound is also preferably a compound having a boiling point of 100°C or higher under normal pressure. Examples thereof include a monofunctional acrylate or methacrylate such as polyethylene glycol mono(meth)acrylate, polypropylene glycol mono(meth)acrylate or phenoxyethyl (meth)acrylate; a polyfunctional acrylate or methacrylate, such as polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl)ether, tri(acryloyloxyethyl)isocyanurate, a compound obtained by adding ethylene oxide or propylene oxide to a polyfunctional alcohol such as glycerin or trimethylolethane, followed by (meth)acrylation, urethane (meth)acrylates as described in JP1973-41708B (JP-S48-41708B), JP1975-6034B (JP-S50-6034B) and JP1976-37193A (JP-S51-37193A), polyester acrylates described in JP1973-64183A (JP-S48-64183A), JP1974-43191B (JP-S49-43191B) and JP1977-30490B (JP-S52-30490B), and epoxy acrylates as a reaction product of an epoxy resin and a (meth)acrylic acid; and a mixture thereof. Further, the compounds described in paragraphs "0254" to "0257" of JP2008-292970A are also suitable. A polyfunctional (meth)acrylate obtained by reacting a polyfunctional carboxylic acid with a compound having a cyclic ether group and an ethylenically unsaturated bond, such as glycidyl (meth)acrylate may also be exemplified.

As other preferred polymerizable compounds, compounds having a fluorene ring and containing two or more groups having an ethylenically unsaturated bond described in JP2010-160418A, JP2010-129825A and Japanese Patent No. 4364216, and a cardo resin may also be used.

Further, as other examples of the polymerizable compound, specific unsaturated compounds described in JP1971-43946B (JP-S46-43946B), JP1989-40337B (JP-H1-40337B) and JP1989-40336B (JP-H1-40336B), and vinylphosphonic acid compounds described in JP1990-25493A (JP-H2-25493A) can also be exemplified. In some cases, a structure containing a perfluoroalkyl group described in JP1986-22048A (JP-S61-22048A) is suitably used. Moreover, photocurable monomers or oligomers described in Journal of Japan Adhesiveness Society, Vol. 20, No. 7, pp. 300 to 308 (1984) can also be used.

In addition, polymerizable compounds represented by the following General Formulae (MO-1) to (MO-5) may also be suitably used. In the formulae, in a case where T is an oxyalkylene group, the terminal on the carbon atom side thereof is bonded to R.

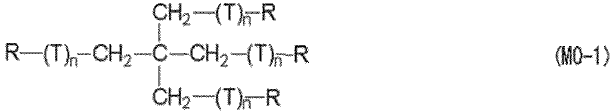

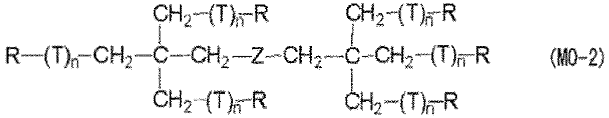

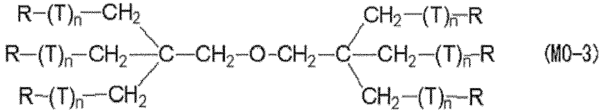

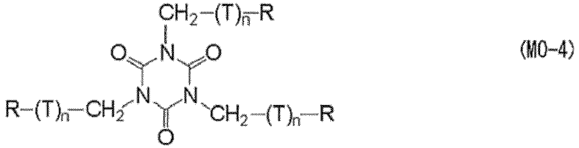

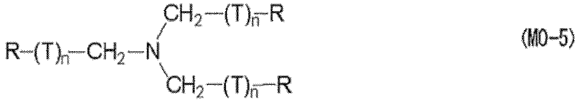

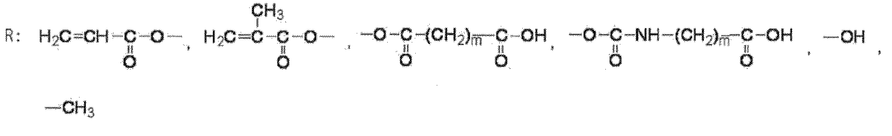

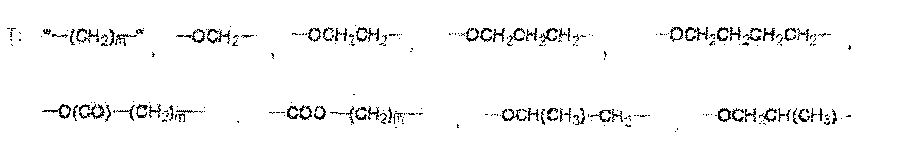

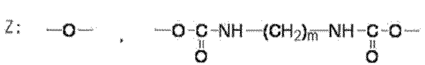

In the general formulae, n is an integer of 0 to 14 and m is an integer of 1 to 8. In a case where plural R's or plural T's are present in one molecule, plural R's or plural T's may be the same or different from each other.

In each of the polymerizable compounds represented by General Formulae (MO-1) to (MO-5), at least one of plural R's represents a group represented by -OC(=O)CH=CH₂ or -OC(=O)C(CH₃)=CH₂.

As to specific examples of the polymerizable compounds represented by General Formulae (MO-1) to (MO-5), the compounds described in paragraphs "0248" to "0251" of JP2007-269779A may be suitably used also in the present invention.

Compounds obtained by adding ethylene oxide or propylene oxide to a polyfunctional alcohol and then (meth)acrylating the adduct, described as General Formulae (1) and (2) together with their specific examples in JP1998-62986A (JP-H10-62986A), may also be used as the polymerizable compound.

Preferred polymerizable compounds include dipentaerythritol triacrylate (as a commercially available product, KAYARAD D-330, manufactured by Nippon Kayaku Co., Ltd.), dipentaerythritol tetraacrylate (as a commercially available product, KAYARAD D-320, manufactured by Nippon Kayaku Co., Ltd.), dipentaerythritol penta(meth)acrylate (as a commercially available product, KAYARAD D-310, manufactured by Nippon Kayaku Co., Ltd.), dipentaerythritol hexa(meth)acrylate (as a commercially available product, KAYARAD DPHA, manufactured by Nippon Kayaku Co., Ltd.), and structures where the (meth)acryloyl group of the compounds described above are connected through ethylene glycol or propylene glycol residue. Oligomer types of these compounds may also be used.

The polymerizable compound may be a polyfunctional monomer having an acid group such as a carboxyl group, a sulfonic acid group or a phosphoric acid group. The polyfunctional monomer having an acid group is preferably an ester of an aliphatic polyhydroxy compound and an unsaturated carboxylic acid, more preferably a polyfunctional monomer which is obtained by reacting a non-aromatic carboxylic anhydride with an unreacted hydroxyl group of the aliphatic polyhydroxy compound to introduce the acid group, and particularly preferably the ester described above where the aliphatic polyhydroxy compound is pentaerythritol and/or dipentaerythritol. Examples of the commercially available product thereof include polybasic acid-modified acryl oligomers M-510 and M-520 manufactured by Toagosei Co., Ltd.

The polyfunctional monomers having an acid group may be used alone or in combination of two or more thereof. Further, a polyfunctional monomer having no acid group and a polyfunctional monomer having an acid group may be used in combination, if desired.

The acid value of the polyfunctional monomer having an acid group is preferably 0.1 to 40 mgKOH/g, and particularly preferably 5 to 30 mgKOH/g. If the acid value of the polyfunctional monomer is within the above-specified range, the production or handleability thereof becomes excellent and furthermore, developability becomes excellent. In addition, curability is favorable.

The polymerizable compound may also employ a polymerizable compound having a caprolactone structure.

The polymerizable compound having a caprolactone structure is not particularly limited as long as it has a caprolactone structure in the molecule thereof, and examples thereof include an ε-caprolactone-modified polyfunctional (meth)acrylate obtained by esterification of a polyhydric alcohol, for example, trimethylolethane, ditrimethylolethane, trimethylolpropane, ditrimethylolpropane, pentaerythritol, dipentaerythritol, tripentaerythritol, glycerin, diglycerol or trimethylolmelamine with (meth)acrylic acid and ε-caprolactone. Among them, preferred is a polymerizable compound having a caprolactone structure represented by the following General Formula (B).

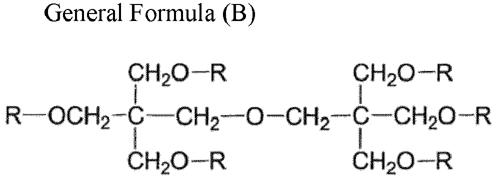

(In the formula, all of six R's are a group represented by the following General Formula (C), or one to five of six R's are a group represented by the following General Formula (C) and the remainder is a group represented by the following General Formula (D)).

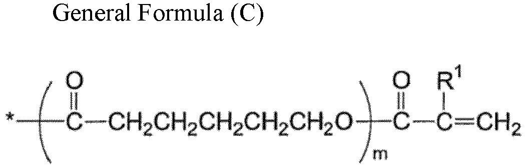

(In the formula, R¹ represents a hydrogen atom or a methyl group, m represents the number of 1 or 2, and "^{∗}" represents a connecting portion)

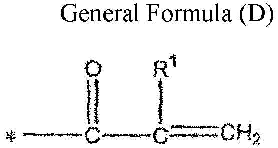

### (In the formula, R¹ represents a hydrogen atom or a methyl group, and "^{∗}" represents a connecting portion)

The polymerizable compound having a caprolactone structure is commercially available as KAYARAD DPCA Series from Nippon Kayaku Co., Ltd. and includes DPCA-20 (compound represented by General Formulae (B) to (D), where m is 1, the number of the group represented by General Formula (C) is 2, and all of R¹ are a hydrogen atom), DPCA-30 (compound represented by General Formulae (B) to (D), where m is 1, the number of the group represented by General Formula (C) is 3, and all of R¹ are a hydrogen atom), DPCA-60 (compound represented by General Formulae (B) to (D), where m is 1, the number of the group represented by General Formula (C) is 6, and all of R¹ are a hydrogen atom), and DPCA-120 (compound represented by General Formulae (B) to (D), where m is 2, the number of the group represented by General Formula (C) is 6, and all of R¹ are a hydrogen atom).

The polymerizable compounds having a caprolactone structure may be used alone or in combination of two or more thereof in the present invention.

The polymerizable compound is also preferably at least one selected from the group of compounds represented by the following General Formula (i) or (ii). 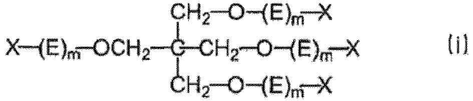 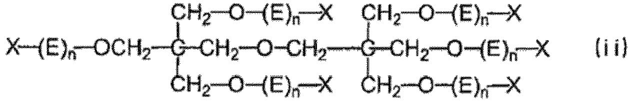 General Formulae (i) and (ii), E's each independently represent -((CH₂)_{y}CH₂O)- or -((CH₂)_{y}CH(CH₃)O)- in which y's each independently represent an integer of 0 to 10, and X's each independently represent a (meth)acryloyl group, a hydrogen atom, or a carboxyl group.

In General Formula (i), the total number of (meth)acryloyl groups is 3 or 4, m's each independently represent an integer of 0 to 10, and the total of each m is an integer of 0 to 40, provided that in a case where the total number of each m is 0, any one of X's is a carboxyl group.

In General Formula (ii), the total number of (meth)acryloyl groups is 5 or 6, n's each independently represent an integer of 0 to 10, and the total number of each n is an integer of 0 to 60, provided that in a case where the total number of each n is 0, any one of X's is a carboxyl group.

In General Formula (i), m is preferably an integer of 0 to 6, and more preferably an integer of 0 to 4.

The total of each m is preferably an integer of 2 to 40, more preferably an integer of 2 to 16, and particularly preferably an integer of 4 to 8.

In General Formula (ii), n is preferably an integer of 0 to 6, and more preferably an integer of 0 to 4.

The total of each n is preferably an integer of 3 to 60, more preferably an integer of 3 to 24, and particularly preferably an integer of 6 to 12.

An embodiment where, in -((CH₂)_{y}CH₂O)- or -((CH₂)_{y}CH(CH₃)O)- in General Formula (i) or General Formula (ii), the terminal on the oxygen atom side is bonded to X is preferred. In particular, an embodiment where all of six X's in General Formula (ii) are an acryloyl group is preferred.

The compound represented by General Formula (i) or (ii) can be synthesized through a step of connecting a ring-opened skeleton of ethylene oxide or propylene oxide to pentaerythritol or dipentaerythritol by a ring-opening addition reaction, and a step of introducing a (meth)acryloyl group into the terminal hydroxyl group of the ring-opened skeleton by reacting, for example, (meth)acryloyl chloride, which are conventionally known steps. Each step is a well-known step and the compound represented by General Formula (i) or (ii) can be easily synthesized by a person skilled in the art.

Of the compounds represented by General Formulae (i) and (ii), a pentaerythritol derivative and/or a dipentaerythritol derivative is more preferred.

Specific examples of the compounds include compounds represented by the following Formulae (a) to (f) (hereinafter, also referred to as "Exemplary Compounds (a) to (f)"). Among them, Exemplary Compounds (a), (b), (e), and (f) are preferred.

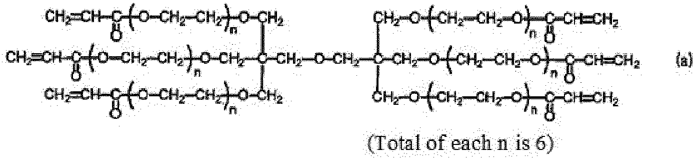

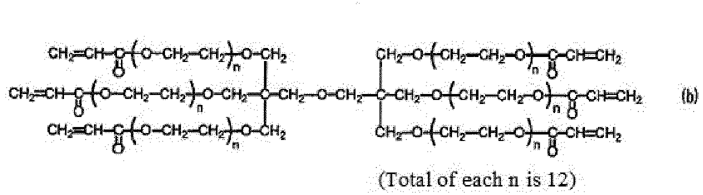

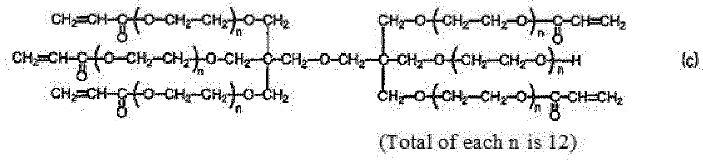

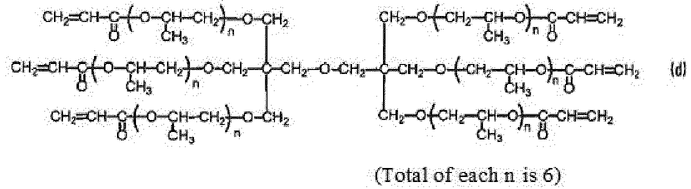

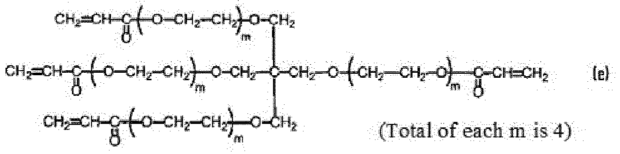

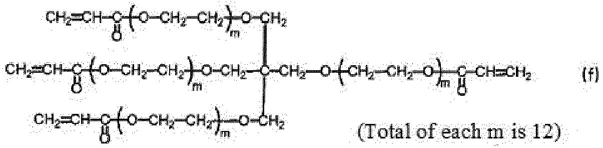

Examples of commercially available products of the polymerizable compounds represented by General Formulae (i) and (ii) include SR-494, which is a tetrafunctional acrylate having four ethyleneoxy chains, manufactured by Sartomer Company, and DPCA-60, which is a hexafunctional acrylate having six pentyleneoxy chains and TPA-330, which is a trifunctional acrylate having three isobutyleneoxy chains, both manufactured by Nippon Kayaku Co., Ltd.

Furthermore, urethane acrylates as described in JP1973-41708B (JP-S48-41708B), JP1976-37193A (JP-S51-37193A), JP1990-32293B (JP-H2-32293B) and JP1990-16765B (JP-H2-16765B), and urethane compounds having an ethylene oxide skeleton described in JP1983-49860B (JP-S58-49860B), JP1981-17654B (JP-S56-17654B), JP1987-39417B (JP-S62-39417B) and JP1987-39418B (JP-S62-39418B) are also suitable as the polymerizable compound. In addition, addition-polymerizable monomers having an amino structure or a sulfide structure in the molecule thereof described in JP1988-277653A (JP-S63-277653A), JP1988-260909A (JP-S63-260909A) and JP1989-105238A (JP-H1-105238A) may also be used as the polymerizable compound.

Examples of commercially available products of the polymerizable compound include urethane oligomers UAS-10 and UAB-140 (manufactured by Sanyo Kokusaku Pulp Co., Ltd.), NK ester M-40G, NK ester 4G, NK ester M-9300, NK ester A-9300, and UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600 and AI-600 (manufactured by Kyoeisha Chemical Co., Ltd.), and BLEMMER PME400 (manufactured by NOF Co., Ltd.).

From the viewpoint of heat resistance, the polymerizable compound preferably has a partial structure represented by the following formula. 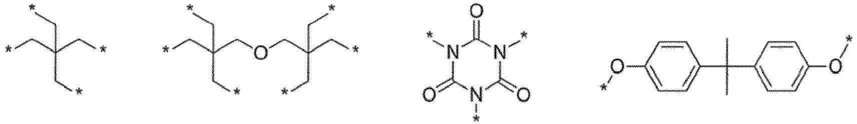 ^{∗} in the formula is a connecting portion.

Specific examples of the polymerizable compound having a partial structure include trimethylolpropane tri(meth)acrylate, isocyanuric acid ethylene oxide-modified di(meth)acrylate, isocyanuric acid ethylene oxide-modified tri(meth)acrylate, pentaerythritol tri(meth)acrylate, pentaerythritol tetra(meth)acrylate, dimethylolpropane tetra(meth)acrylate, dipentaerythritol penta(meth)acrylate, dipentaerythritol hexa(meth)acrylate, and tetramethylolmethane tetra(meth)acrylate. These polymerizable compounds can be particularly preferably used in the present invention.

From the viewpoint of good curability and heat resistance, the content of the polymerizable compound in the thermosetting resin composition is preferably 1 to 50 mass% with respect to the total solid content of the thermosetting resin composition. The lower limit is more preferably 5 mass% or more. The upper limit is more preferably 30 mass% or less. The polymerizable compounds may be used alone or in combination of two or more thereof.

The mass ratio of thermosetting resin:polymerizable compound (thermosetting resin/polymerizable compound) is preferably 98/2 to 10/90, more preferably 95/5 to 30/70, and most preferably 90/10 to 50/50. If the mass ratio of thermosetting resin:polymerizable compound is within the above-specified range, a cured film having superior curability and heat resistance can be formed.

### <<Thermal polymerization initiator>>

The thermosetting resin composition of the present invention may contain a thermal polymerization initiator. A known thermal polymerization initiator may be used as the thermal polymerization initiator.

The thermal polymerization initiator is a compound which generates radicals with heat energy to initiate or accelerate a polymerization reaction of a polymerizable compound. By adding a thermal polymerization initiator, the polymerization reaction of the polymerizable compound can be proceeded when the cyclization reaction of a thermosetting resin is allowed to proceed. Further, in a case where the thermosetting resin contains an ethylenically unsaturated bond, it would become possible to achieve being of higher heat resistance since the polymerization reaction of a thermosetting resin can also be proceeded together with the cyclization of a thermosetting resin.

Examples of the thermal polymerization initiator include aromatic ketones, an onium salt compound, a peroxide, a thio compound, a hexaarylbiimidazole compound, a ketoxime ester compound, a borate compound, an azinium compound, a metallocene compound, an active ester compound, a compound having a carbon-halogen bond, and an azo compound. Among them, a peroxide and an azo compound are more preferred, and a peroxide is particularly preferred.

Specifically, the compounds described in paragraphs "0074" to "0118" of JP2008-63554A are exemplified.

As a commercially available product, PERBUTYL Z (manufactured by NIPPON OIL & FATS CO., LTD.) can be suitably used.

In a case where the thermosetting resin composition contains a thermal polymerization initiator, the content of the thermal polymerization initiator is preferably 0.1 to 50 mass%, more preferably 0.1 to 30 mass%, and particularly preferably 0.1 to 20 mass%, with respect to the total solid content of the thermosetting resin composition. Further, the thermal polymerization initiator is contained an amount of preferably 0.1 to 50 parts by mass, and more preferably 0.5 to 30 parts by mass, with respect to 100 parts by mass of the polymerizable compound. According to this aspect, it is easy to form a cured film having superior heat resistance.

The thermal polymerization initiator may be only one type or may be two or more types. In a case where the thermal polymerization initiator is two or more types, it is preferred that the total thereof is within the above-specified range.

### «Sensitizing dye»

The thermosetting resin composition of the present invention may contain a sensitizing dye. The sensitizing dye becomes an electron excited state by absorbing specific actinic radiations. The sensitizing dye in the electronically excited state comes into contact with, e.g., a thermal base generator, a thermal polymerization initiator or a photopolymerization initiator, resulting in actions such as electron transfer, energy transfer, and heat generation. Thus, a thermal base generator, a thermal polymerization initiator, or a photopolymerization initiator undergoes chemical changes to be decomposed, thereby generating a radical, an acid or a base.

Preferred examples of the sensitizing dye include those which belong to the following compounds and have an absorption wavelength in a region of 300 nm to 450 nm. For example, polynuclear aromatic compounds (for example, phenanthrene, anthracene, pyrene, perylene, triphenylene, and 9,10-dialkoxyanthracene), xanthenes (for example, fluorescein, eosin, erythrosine, rhodamine B, and rose bengal), thioxanthones, cyanines (for example, thiacarbocyanine, and oxacarbocyanine), merocyanines (for example, merocyanine and carbomerocyanine), thiazines (for example, thionine, methylene blue, and toluidine blue), acridines (for example, acridine orange, chloroflavin, and acriflavin), anthraquinones (for example, anthraquinone), squaryliums (for example, squarylium), coumarins (for example, 7-diethylamino-4-methylcoumarin), phenothiazines, styryl benzenes, distyryl benzenes, and carbazoles are exemplified.

In the present invention, it is preferred to combine with polynuclear aromatic compounds (for example, phenanthrene, anthracene, pyrene, perylene, and triphenylene), thioxanthones, distyryl benzenes, or styryl benzenes from the viewpoint of initiation efficiency, and it is more preferred to use a compound having an anthracene skeleton. Examples of the particularly preferred specific compound include 9,10-diethoxyanthracene and 9,10-dibutoxyanthracene.

In a case where the thermosetting resin composition contains a sensitizing dye, the content of the sensitizing dye is preferably 0.01 to 20 mass%, more preferably 0.1 to 15 mass%, and still more preferably 0.5 to 10 mass%, with respect to the total solid content of the thermosetting resin composition. The sensitizing dyes may be used alone or in combination of two or more thereof.

### <<Photopolymerization initiator>>

The thermosetting resin composition of the present invention may contain a photopolymerization initiator. By including the photopolymerization initiator in the thermosetting resin composition, it is possible to decrease the solubility in a light-irradiated area by applying the thermosetting resin composition onto, e.g., a semiconductor wafer to form a composition layer of a layer shape, and then irradiating the layer with light, thus resulting in curing of the layer by radicals or acid. Thus, for example, by exposing the composition layer through a photomask having a pattern of masking only an electrode portion, there is an advantage that it is possible to easily prepare regions whose solubility is different in accordance with the pattern of the electrode.

The photopolymerization initiator is not particularly limited as long as it has an ability to initiate a polymerization reaction (crosslinking reaction) of a polymerizable compound, and can be appropriately selected from known photopolymerization initiators. For example, a photopolymerization initiator having photosensitivity to light from an ultraviolet region to a visible region is preferred. Also, the photopolymerization initiator may be an activator which causes any action with a photo-excited sensitizer to produce an active radical.

Further, it is preferred that the photopolymerization initiator contains at least one compound having a molecular light absorption coefficient of at least about 50 within the range of about 300 to 800 nm (preferably 330 to 500 nm). The molar light absorption coefficient of the compound can be measured by using a known method, and specifically, it is preferred that the molar absorption coefficient is measured, for example, by a UV-Vis spectrophotometer (Cary-5 spectrophotometer, manufactured by Varian, Inc.) using an ethyl acetate solvent at a concentration of 0.01 g/L.

As the photopolymerization initiator, known compounds are used without limitation. Examples of the photopolymerization initiator include a halogenated hydrocarbon derivative (for example, a compound having a triazine skeleton, a compound having an oxadiazole skeleton or a compound having a trihalomethyl group), an acylphosphine compound, for example, an acylphosphine oxide, a hexaarylbiimidazole, an oxime compound, for example, an oxime derivative, an organic peroxide, a thio compound, a ketone compound, an aromatic onium salt, a ketoxime ether, an aminoacetophenone compound, a hydroxyacetophenone, an azo compound, an azide compound, a metallocene compound, an organic boron compound, and an iron arene complex.

The halogenated hydrocarbon compound having a triazine skeleton includes, for example, compounds described in Wakabayashi et al., Bull. Chem. Soc. Japan, 42, 2924 (1969), compounds described in British Patent 1388492, compounds described in JP1978-133428A (JP-S53-133428A), compounds described in German Patent 3337024, compounds described in F. C. Schaefer et al., J. Org. Chem., 29, 1527 (1964), compounds described in JP1987-58241A (JP-S62-58241A), compounds described in JP1993-281728A (JP-H5-281728A), compounds described in JP1993-34920A (JP-H5-34920A), and compounds described in US4212976A.

The compounds described in US4212976A include, for example, compounds having an oxadiazole skeleton (for example, 2-trichloromethyl-5-phenyl-1,3,4-oxadiazole, 2-trichloromethyl-5-(4-chlorophenyl)-1,3,4-oxadiazole, 2-trichloromethyl-5-(1-naphthyl)-1,3,4-oxadiazole, 2-trichloromethyl-5-(2-naphthyl)-1,3,4-oxadiazole, 2-tribromomethyl-5-phenyl-1,3,4-oxadiazole, 2-tribromomethyl-5-(2-naphthyl)-1,3,4-oxadiazole, 2-trichloromethyl-5-styryl-1,3,4-oxadiazole, 2-trichloromethyl-5-(4-chlorostyryl)-1,3,4-oxadiazole, 2-trichloromethyl-5-(4-methoxystyryl)-1,3,4-oxadiazole, 2-trichloromethyl-5-(1-naphthyl)-1,3,4-oxadiazole, 2-trichloromethyl-5-(4-n-buthoxystyryl)-1,3,4-oxadiazole, and 2-tribromomethyl-5-styryl-1,3,4-oxadiazole).

Also, examples of the photopolymerization initiator other than the photopolymerization initiators described above include an acridine derivative (for example, 9-phenylacridine or 1,7-bis(9,9'-acridinyl)heptane), N-phenylglycine, a polyhalogen compound (for example, carbon tetrabromide, phenyl tribromomethyl sulfone or phenyl trichloromethyl ketone), coumarins (for example, 3-(2-benzofuranoyl)-7-diethylaminocoumarin, 3-(2-benzofuroyl)-7-(1-pyrrolidinyl)coumarin, 3-benzoyl-7-diethylaminocoumarin, 3-(2-methoxybenzoyl)-7-diethylaminocoumarin, 3-(4-dimethylaminobenzoyl)-7-diethylaminocoumarin, 3,3'-carbonylbis(5,7-di-n-propoxycoumarin), 3,3'-carbonylbis(7-diethylaminocoumarin), 3-benzoyl-7-methoxycoumarin, 3-(2-furoyl)-7-diethylaminocoumarin, 3-(4-diethylaminocinnamoyl)-7-diethylaminocoumarin, 7-methoxy-3-(3-pyridylcarbonyl)coumarin, 3-benzoyl-5,7-dipropoxycoumarin, 7-benzotriazol-2-ylcoumarin, coumarin compounds described, for example, in JP1993-19475A (JP-H5-19475A), JP1995-271028A (JP-H7-271028A), JP2002-363206A, JP2002-363207A, JP2002-363208A and JP2002-363209A), acylphosphine oxides (for example, bis(2,4,6-trimethylbenzoyl)-phenylphosphine oxide, bis(2,6-dimethoxybenzoyl)-2,4,4-trimethyl-pentylphenylphosphine oxide, and Lucirin TPO), metallocenes (for example, bis(η5-2,4-cyclopentadien-1-yl)-bis(2,6-difluoro-3-(1H-pyrrol-1-yl)phenyl)titanium, and η 5-cyclopentadienyl-η6-cumenyl-iron(1+)-hexafluorophosphate(1-)), and compounds described in JP1978-133428A (JP-S53-133428A), JP1982-1819B (JP-S57-1819B), JP1982-6096B (JP-S57-6096B) and US3615455A.

Examples of the ketone compound include benzophenone, 2-methylbenzophenone, 3-methylbenzophenone, 4-methylbenzophenone, 4-methoxybenzophenone, 2-chlorobenzophenone, 4-chlorobenzophenone, 4-bromobenzophenone, 2-carboxybenzophenone, 2-ethoxycarbonylbenzophenone, benzophenone tetracarboxylic acid or a tetramethyl ester thereof, 4,4'-bis(dialkylamino)benzophenones (for example, 4,4'-bis(dimethylamino)benzophenone, 4,4'-bis(dicyclohexylamino)benzophenone, 4,4'-bis(diethylamino)benzophenone, 4,4'-bis(dihydroxyethylamino)benzophenone, 4-methoxy-4' -dimethylaminobenzophenone, 4,4' -dimethoxybenzophenone), 4-dimethylaminobenzophenone, and 4-dimethylaminoacetophenone, benzyl, anthraquinone, 2-t-butylanthraquinone, 2-methylanthraquinone, phenanthraquinone, xanthone, thioxanthone, 2-chloro-thioxanthone, 2,4-diethylthioxanthone, fluorenone, 2-benzyl-dimethylamino-1-(4-morpholinophenyl)-1-butanone, 2-methyl-1-[4-(methylthio)phenyl]-2-morpholino-1-propanone, 2-hydroxy-2-methyl-[4-(1-methylvinyl)phenyl]propanol oligomer, benzoin, benzoin ethers (for example, benzoin methyl ether, benzoin ethyl ether, benzoin propyl ether, benzoin isopropyl ether, benzoin phenyl ether and benzyl dimethyl ketal), acridone, chloroacridone, N-methylacridone, N-butylacridone, and N-butyl-chloroacridone.

As a commercially available product, KAYACURE DETX (manufactured by Nippon Kayaku Co., Ltd.) is also preferably used.

As the photopolymerization initiator, a hydroxyacetophenone compound, an aminoacetophenone compound and an acylphosphine compound may also be preferably used. More specifically, for example, an aminoacetophenone initiator described in JP1998-291969A (JP-H10-291969A) and an acylphosphine oxide initiator described in Japanese Patent No. 4225898 may also be used.

As the hydroxyacetophenone initiator, IRGACURE-184, DAROCUR-1173, IRGACURE-500, IRGACURE-2959 and IRGACURE-127 (trade names, all manufactured by BASF Corp.) may be used.

As the aminoacetophenone initiator, commercially available products of IRGACURE-907, IRGACURE-369, and IRGACURE-379 (trade names, all manufactured by BASF Corp.) may be used.

As the aminoacetophenone initiator, compounds described in JP2009-191179A, where the absorption wavelength matches a light source having a long wavelength, for example, 365 nm or 405 nm, may also be used.

As the acylphosphine initiator, commercially available products of IRGACURE-819 and DAROCUR-TPO (trade names, both manufactured by BASF Corp.) may be used.

The photopolymerization initiator more preferably includes an oxime compound. As specific examples of the oxime initiator, compounds described in JP2001-233842A, compounds describe in JP2000-80068A and compounds described in JP2006-342166A may be used.

Preferred examples of the oxime compound include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one.

The oxime compound includes, for example, compounds described in J. C. S. Perkin II, (1979) pp. 1653 to 1660, J. C. S. Perkin II, (1979) pp. 156 to 162, Journal of Photopolymer Science and Technology, (1995) pp 202 to 232, JP2000-66385A, JP2000-80068A, JP2004-534797A, and JP2006-342166A.

As the commercially available products of the oxime compound, IRGACURE-OXE01 (manufactured by BASF Corp.), IRGACURE-OXE02 (manufactured by BASF Corp.), and N-1919 (manufactured by ADEKA Corporation) are also preferably used.

In addition, as the oxime compound, compounds described in JP2009-519904A, where oxime is connected to the N-position of carbazole, compounds described in US7626957B, where a hetero-substituent is introduced into the benzophenone moiety, compounds described in JP2010-15025A and US2009/292039A, where a nitro group is introduced into the dye moiety, ketoxime compounds described in WO2009/131189A, compounds containing a triazine skeleton and an oxime skeleton in the same molecule described in US7556910B, and compounds having an absorption maximum at 405 nm and exhibiting good sensitivity for a g-line light source described in JP2009-221114A may also be used.

Further, cyclic oxime compounds described in JP2007-231000A and JP2007-322744A may also be preferably used. Of the cyclic oxime compounds, cyclic oxime compounds condensed to a carbazole dye described in JP2010-32985A and JP2010-185072A have high light absorptivity and thus are preferred from the viewpoint of high sensitivity.

Further, compounds described in JP2009-242469A having an unsaturated bond at a specific site of an oxime compound may also be preferably used.

Further, it is also possible to use an oxime initiator having a fluorine atom. Specific examples of such an initiator include compounds described in JP2010-262028A, Compounds 24, and 36 to 40 described in paragraph "0345" of JP2014-500852A, and Compound (C-3) described in paragraph "0101" of JP2013-164471A. Specific examples thereof include the following compounds.

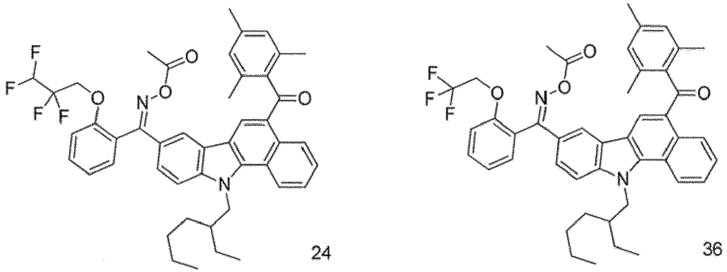

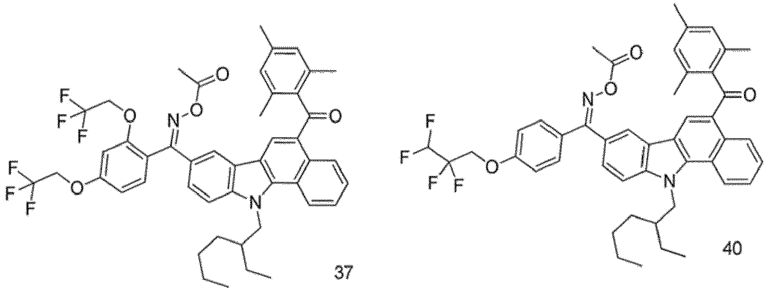

Oxime compounds having a specific substituent described in JP2007-269779A and oxime compounds having a thioaryl group described in JP2009-191061A are most preferred.

From the viewpoint of exposure sensitivity, the photopolymerization initiator is preferably a compound selected from the group consisting of a trihalomethyltriazine compound, a benzyl dimethyl ketal compound, an α-hydroxyketone compound, an α -aminoketone compound, an acylphosphine compound, a phosphine oxide compound, a metallocene compound, an oxime compound, a triarylimidazole dimer, an onium compound, a benzothiazole compound, a benzophenone compound, an acetophenone compound and a derivative thereof, a cyclopentadiene-benzene-iron complex and a salt thereof, a halomethyloxadiazole compound and a 3-aryl-substituted coumarin compound.

More preferred is a trihalomethyltriazine compound, an α-aminoketone compound, an acyl phosphine compound, a phosphine oxide compound, an oxime compound, a triarylimidazole dimer, an onium compound, a benzophenone compound or an acetophenone compound, and most preferred is at least one compound selected from the group consisting of a trihalomethyltriazine compound, an α-aminoketone compound, an oxime compound, a triarylimidazole dimer and a benzophenone compound is most preferred. It is most preferred to use an oxime compound.

As the photopolymerization initiator, a compound which generates an acid having a pKa of 4 or less can also be preferably used, and a compound which generates an acid having a pKa of 3 or less is more preferred.

Examples of the compound which generates an acid include trichloromethyl-s-triazines, a sulfonium salt, an iodonium salt, quaternary ammonium salts, a diazomethane compound, an imidosulfonate compound, and an oximesulfonate compound. Among these compounds, an oximesulfonate compound is preferably used from the viewpoint of high sensitivity. These acid generators may be used alone or in combination of two or more thereof.

The acid generator specifically includes acid generators described in paragraphs "0073" to "0095" of JP2012-8223A.

In a case where the thermosetting resin composition contains a photopolymerization initiator, the content of the photopolymerization initiator is preferably 0.1 to 30 mass%, more preferably 0.1 to 20 mass%, and still more preferably 0.1 to 10 mass%, with respect to the total solid content of the thermosetting resin composition. Further, the photopolymerization initiator is contained in an amount of preferably 1 to 20 parts by mass, and more preferably 3 to 10 parts by mass, with respect to 100 parts by mass of the polymerizable compound.

The photopolymerization initiator may be only one type or may be two or more types. In a case where the photopolymerization initiator is two or more types, it is preferred that the total thereof is within the above-specified range.

### <<Chain transfer agent>>

The thermosetting resin composition of the present invention may contain a chain transfer agent. The chain transfer agent is defined, for example, in Polymer Dictionary, Third Edition, pp. 683 and 684, edited by The Society of Polymer Science, Japan (2005). As the chain transfer agent, for example, a group of compounds having SH, PH, SiH or GeH in their molecules is used. Such a compound group donates a hydrogen to a low active radical species to generate a radical or is oxidized and then deprotonated to generate a radical. In particular, thiol compounds (for example, 2-mercaptobenzimidazoles, 2-mercaptobenzothiazoles, 2-mercaptobenzoxazoles, 3-mercaptotriazoles or 5-mercaptotetrazoles) are preferably used.

In a case where the thermosetting resin composition contains a chain transfer agent, the preferred content of the chain transfer agent is preferably 0.01 to 20 parts by mass, more preferably 1 to 10 parts by mass, and particularly preferably 1 to 5 parts by mass, with respect to 100 parts by mass of the total solid content of the thermosetting resin composition.

The chain transfer agent may be only one type or may be two or more types. In a case where the chain transfer agent is two or more types, it is preferred that the total thereof is within the above-specified range.

### «Polymerization inhibitor»

The thermosetting resin composition of the present invention preferably contains a small amount of a polymerization inhibitor in order to inhibit unnecessary thermal polymerization of a thermosetting resin and a polymerizable compound during production or preservation of the composition.

Suitable examples of the polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

In a case where the thermosetting resin composition contains a polymerization inhibitor, the content of the polymerization inhibitor is preferably 0.01 to 5 mass% with respect to the total solid content of the thermosetting resin composition.

The polymerization inhibitor may be only one type or may be two or more types. In a case where the polymerization inhibitor is two or more types, it is preferred that the total thereof is within the above-specified range.

### «Higher fatty acid derivative or the like»

In order to prevent polymerization inhibition due to oxygen, a higher fatty acid derivative or the like, for example, behenic acid or behenic acid amide may be added to the thermosetting resin composition of the present invention to localize on the surface of a thermosetting resin composition in the process of drying after the coating.

In a case where the thermosetting resin composition contains a higher fatty acid derivative, the content of the higher fatty acid derivative is preferably 0.1 to 10 mass% with respect to the total solid content of the thermosetting resin composition.

The higher fatty acid derivative or the like may be only one type or may be two or more types. In a case where the higher fatty acid derivative or the like is two or more types, it is preferred that the total thereof is within the above-specified range.

### <<Solvent>>

In a case where the thermosetting resin composition of the present invention is layered by coating, it is preferred to blend a solvent. A known solvent may be used without limitation, as long as it is capable of forming the thermosetting resin composition into a layer.

The solvent preferably includes, as esters, for example, ethyl acetate, n-butyl acetate, isobutyl acetate, amyl formate, isoamyl acetate, isobutyl acetate, butyl propionate, isopropyl butyrate, ethyl butyrate, butyl butyrate, methyl lactate, ethyl lactate, γ-butyrolactone, ε-caprolactone, δ-valerolactone, alkyl oxyacetate (for example, methyl oxyacetate, ethyl oxyacetate, butyl oxyacetate (for example, methyl methoxyacetate, ethyl methoxyacetate, butyl methoxyacetate, methyl ethoxyacetate or ethyl ethoxyacetate)), alkyl 3-oxypropionates (for example, methyl 3-oxypropionate and ethyl 3-oxypropionate (for example, methyl 3-methoxypropionate, ethyl 3-methoxypropionate, methyl 3-ethoxypropionate or ethyl 3-ethoxypropionate)), alkyl 2-oxypropionates (for example, methyl 2-oxypropionate, ethyl 2-oxypropionate, and propyl 2-oxypropionate (for example, methyl 2-methoxypropionate, ethyl 2-methoxypropionate, propyl 2-methoxypropionate, methyl 2-ethoxypropionate or ethyl 2-ethoxypropionate)), methyl 2-oxy-2-methylpropionate and ethyl 2-oxy-2-methylpropionate (for example, methyl 2-methoxy-2-methylpropionate or ethyl 2-ethoxy-2-methylpropionate), methyl pyruvate, ethyl pyruvate, propyl pyruvate, methyl acetoacetate, ethyl acetoacetate, methyl 2-oxobutanoate or ethyl 2-oxobutanoate; as ethers, for example, diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate or propylene glycol monopropyl ether acetate; as ketones, for example, methyl ethyl ketone, cyclohexanone, cyclopentanone, 2-heptanone, 3-heptanone, and N-methyl-2-pyrrolidone; as aromatic hydrocarbons, for example, toluene, xylene, anisole, and limonene; and as sulfoxides, for example, dimethyl sulfoxide.

From the viewpoint of improving, e.g., the coated surface morphology, the solvents are also preferably used in a state of mixinxg two or more thereof. In this case, a mixed solution composed of two or more solvents selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, dimethyl sulfoxide, ethyl carbitol acetate, butyl carbitol acetate, propylene glycol methyl ether and propylene glycol methyl ether acetate is preferred. Combined use of dimethyl sulfoxide and γ-butyrolactone is particularly preferred.

In a case where the thermosetting resin composition contains a solvent, the content of the solvent is set such that the total concentration of solid contents of the thermosetting resin composition becomes preferably 5 to 80 mass%, more preferably 5 to 70 mass%, and particularly preferably 10 to 60 mass%, from the viewpoint of coatability.

The solvent may be only one type or may be two or more types. In a case where the solvent is two or more types, it is preferred that the total thereof is within the above-specified range.

In addition, from the viewpoint of film strength, the content of N-methyl-2-pyrrolidone, N-ethyl-2-pyrrolidone, N,N-dimethylacetamide and N,N-dimethylformamide is preferably less than 5 mass%, more preferably less than 1 mass%, still more preferably less than 0.5 mass%, and particularly preferably less than 0.1 mass%, with respect to the total mass of the composition.

### <<Surfactant>>

From the viewpoint of further improving coatability, various surfactants may be added to the thermosetting resin composition of the present invention. As the surfactant, various surfactants, for example, a fluorine-based surfactant, a nonionic surfactant, a cationic surfactant, an anionic surfactant or a silicone-based surfactant may be used.

In particular, by including a fluorine-based surfactant, liquid properties (particularly, fluidity) of a coating solution prepared are further improved so that the uniformity of coating thickness or the liquid-saving property can be more improved.

In the case of forming a film by using a coating solution containing a fluorine-based surfactant, the interface tension between a surface to be coated and the coating solution is reduced, whereby wettability to the surface to be coated is improved and the coatability on the surface to be coated is increased. This is effective in that even in a case where a thin film of about several µm is formed using a small liquid volume, formation of the film having a little thickness unevenness and a uniform thickness can be more preferably performed.

The fluorine content in the fluorine-based surfactant is preferably 3 to 40 mass%, more preferably 5 to 30 mass%, and particularly preferably 7 to 25 mass%. The fluorine-based surfactant having a fluorine content in the range described above is effective in view of the uniformity of coating thickness and the liquid-saving property and also exhibits good solubility.

Examples of the fluorine-based surfactant include MEGAFAC F171, MEGAFAC F172, MEGAFAC F173, MEGAFAC F176, MEGAFAC F177, MEGAFAC F141, MEGAFAC F142, MEGAFAC F143, MEGAFAC F144, MEGAFAC R30, MEGAFAC F437, MEGAFAC F475, MEGAFAC F479, MEGAFAC F482, MEGAFAC F554, MEGAFAC F780 and MEGAFAC F781 (manufactured by DIC Corp.), FLUORAD FC430, FLUORAD FC431 and FLUORAD FC171 (manufactured by Sumitomo 3M Ltd.), SURFLON S-382, SURFLON SC-101, SURFLON SC-103, SURFLON SC-104, SURFLON SC-105, SURFLON SC-1068, SURFLON SC-381, SURFLON SC-383, SURFLON S393 and SURFLON KH-40 (manufactured by Asahi Glass Co., Ltd.), and PF636, PF656, PF6320, PF6520 and PF7002 (manufactured by OMNOVA Solutions Inc.).

Specific examples of the nonionic surfactant include glycerol, trimethylolpropane, trimethylolethane, ethoxylate and propoxylate thereof (for example, glycerol propoxylate or glycerin ethoxylate), polyoxyethylene lauryl ether, polyoxyethylene stearyl ether, polyoxyethylene oleyl ether, polyoxyethylene octylphenyl ether, polyoxyethylene nonylphenyl ether, polyethylene glycol dilaurate, polyethylene glycol distearate, and sorbitan fatty acid ester (PLURONIC L10, L31, L61, L62, 10R5, 17R2 and 25R2 and TETRONIC 304, 701, 704, 901, 904 and 150R1 (manufactured by BASF Corp.)), SOLSPERSE 20000 (manufactured by The Lubrizol Corp. ), and Olfine (manufactured by Nissin Chemical Industry Co., Ltd.).

Specific examples of the cationic surfactant include a phthalocyanine derivative (trade name: EFKA-745, manufactured by Morishita Sangyo K.K.), an organosiloxane polymer KP341 (manufactured by Shin-Etsu Chemical Co., Ltd.), a (meth)acrylic acid (co)polymers POLYFLOW No. 75, No. 90 and No. 95 (manufactured by Kyoeisha Chemical Co., Ltd.) and W001 (manufactured by Yusho Co., Ltd.).

Specific examples of the anionic surfactant include W004, W005 and W017 (manufactured by Yusho Co., Ltd.).

Examples of the silicone-based surfactant include "TORAY SILICONE DC3PA", "TORAY SILICONE SH7PA", "TORAY SILICONE DC11PA", "TORAY SILICONE SH21PA", "TORAY SILICONE SH28PA", "TORAY SILICONE SH29PA", "TORAY SILICONE SH30PA" and "TORAY SILICONE SH8400" (manufactured by Dow Corning Toray Co., Ltd.), "TSF-4440", "TSF-4300", "TSF-4445", "TSF-4460" and "TSF-4452" (manufactured by Momentive Performance Materials Inc.), "KP341", "KF6001" and "KF6002" (manufactured by Shin-Etsu Silicone Co., Ltd.), and "BYK307", "BYK323" and "BYK330" (manufactured by BYK-Chemie GmbH).

In a case where the thermosetting resin composition contains a surfactant, the content of the surfactant is preferably 0.001 to 2.0 mass%, and more preferably 0.005 to 1.0 mass%, with respect to the total solid content of the thermosetting resin composition.

The surfactant may be only one type or may be two or more types. In a case where the surfactant is two or more types, it is preferred that the total thereof is within the above-specified range.

### <Corrosion inhibitor>

It is preferable to add a corrosion inhibitor to the thermosetting resin composition of the present invention. The corrosion inhibitor is added for the purpose of preventing the outflow of ions from the metal wiring. As a compound, for example, an anticorrosive or the like described in paragraph "0094" of JP2013-15701A may be used. Among them, preferred is a compound having a tetrazole ring, more preferred is 1H-tetrazole or 5-methyl-1H-tetrazole, and most preferred is 1H-tetrazole.

In a case where the thermosetting resin composition contains a corrosion inhibitor, the content of the corrosion inhibitor is preferably 0.001 to 2.0 mass% and more preferably is 0.005 to 1.0 mass%, with respect to the total solid content of the thermosetting resin composition.

The corrosion inhibitor may be only one type or may be two or more types. In a case where the corrosion inhibitor is two or more types, it is preferred that the total thereof is within the above-specified range.

### <Metal adhesiveness improving agent>

The thermosetting resin composition of the present invention preferably contains a metal adhesiveness improving agent for improving adhesiveness to metallic materials used for electrodes or wirings. Examples of the metal adhesiveness improving agent include sulfide compounds described in paragraphs "0046" to "0049" of JP2014-186186A and paragraphs "0032" to "0043" of JP2013-072935A. Examples of the metal adhesiveness improving agent also include the following compounds.

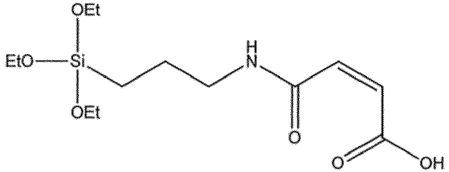

In a case where the thermosetting resin composition contains a metal adhesiveness improving agent, the content of the metal adhesiveness improving agent is preferably 0.001 to 2.0 mass%, and more preferably 0.005 to 1.0 mass%, with respect to the total solid content of the thermosetting resin composition.

The metal adhesiveness improving agent may be only one type or may be two or more types. In a case where the metal adhesiveness improving agent is two or more types, it is preferred that the total thereof is within the above-specified range.

### «Other additives»

The thermosetting resin composition of the present invention may contain, if desired, various additives, for example, a curing agent, a curing catalyst, a silane coupling agent, a filler, an antioxidant, an ultraviolet absorber or an aggregation inhibitor as long as the effects of the present invention are not impaired. In the case of adding such an additive, the total addition amount thereof is preferably set to 3 mass% or less based on the solid content of the thermosetting resin composition.

The water content of the thermosetting resin composition of the present invention is preferably less than 5 mass%, more preferably less than 1 mass%, and particularly preferably less than 0.6 mass%, from the viewpoint of coated surface morphology.

The metal content in the thermosetting resin composition of the present invention is preferably less than 5 ppm, more preferably less than 1 ppm, and particularly preferably less than 0.5 ppm, from the viewpoint of insulating properties. Examples of the metal include sodium, potassium, magnesium, calcium, iron, chromium, and nickel. In a case of containing a plurality of metals, it is preferred that the total of these metals is within the above-specified range.

The content of halogen atoms in the thermosetting resin composition of the present invention is preferably less than 500 ppm, more preferably less than 300 ppm, and particularly preferably less than 200 ppm, from the viewpoint of wiring corrosion preventing properties. Among them, one present in the state of halogen ions is preferably less than 5 ppm, more preferably less than 1 ppm, and particularly preferably less than 0.5 ppm. Examples of the halogen atom include a chlorine atom and a bromine atom. The total of chlorine atoms and bromine atoms, or the total of chloride ions and bromide ions is preferably within the above-specified range.

### <Preparation of thermosetting resin composition>

The thermosetting resin composition of the present invention can be prepared by mixing the above-mentioned individual components. The mixing method is not particularly limited and may be carried out by a conventionally known method.

### <Use of the thermosetting resin composition>

The thermosetting resin composition of the present invention is capable of forming a cured film having excellent heat resistance and insulating properties and therefore can be preferably used for, e.g., an insulating film of semiconductor devices or a re-wiring interlayer insulating film. In particular, the thermosetting resin composition of the present invention can be preferably used, e.g., for re-wiring interlayer insulating film in three-dimensional mounting devices.

Further, the thermosetting resin composition of the present invention can also be used in, e.g., photoresists for electronics (galvanic (electrolysis) resist (galvanic resist), etching resist, or solder top resist).

Further, the thermosetting resin composition of the present invention can also be used in manufacture of printing plates, such as offset printing plates or screen printing plates, for use in etching of molded parts, in electronics, and particularly for production of protective lacquer and dielectric layers in microelectronics.

### <Method of forming cured film>

Next, a method of forming a cured film according to the present invention will be described.

The method of forming a cured film includes a step of applying a thermosetting resin composition onto a substrate, and a step of curing the thermosetting resin composition applied onto the substrate.

### «Step of applying thermosetting resin composition onto substrate»

Examples of the method of applying a thermosetting resin composition onto a substrate include spinning, immersing, doctor-blade coating, suspended casting, painting, spraying, electrostatic spraying and reverse-roll coating. Electrostatic spraying and reverse-roll coating are preferred due to uniform application onto a substrate. It is also possible to introduce a photosensitive layer onto a temporary and flexible carrier and then to coat a final substrate, for example, a copper-covered printed circuit board obtained by layer transfer via lamination.

### Examples of the substrate include an inorganic substrate, a resin, and a resin composite material.

Examples of the inorganic substrate include a glass substrate, a quartz substrate, a silicon substrate, silicon nitride substrate, and a composite substrate in which, e.g., molybdenum, titanium, aluminum, or copper is vapor-deposited onto such a substrate.

Examples of the resin substrate include substrates made of synthetic resins such as polybutylene terephthalate, polyethylene terephthalate, polyethylene naphthalate, polybutylene naphthalate, polystyrene, polycarbonate, polysulfone, polyethersulfone, polyarylate, allyl diglycol carbonate, polyamide, polyimide, polyamideimide, polyetherimide, polybenzazole, polyphenylene sulfide, polycycloolefin, a norbornene resin, a fluororesin, for example polychlorotrifluoroethylene, a liquid crystal polymer, an acrylic resin, an epoxy resin, a silicone resin, an ionomer resin, a cyanate resin, crosslinked fumaric acid diester, cyclic polyolefin, aromatic ether, maleimide-olefin, cellulose, and an episulfide compound. A case of these substrates being used in the above-mentioned form is uncommon, and usually depending on the form of the final product, a multilayer laminate structure such as a TFT element is formed thereon.

The amount of the thermosetting resin composition to be applied (thickness of layer) and the type of the substrate (carrier of layer) are dependent on the field of applications which are desired. It is particularly advantageous that the thermosetting resin composition can be used in a widely variable layer thickness. The range of layer thickness is preferably 0.5 to 100 µm.

After applying the thermosetting resin composition onto the substrate, it is preferred to carry out drying. The drying is preferably carried out, for example, at 60°C to 150°C for 10 seconds to 2 minutes.

### «Step of heating»

By heating the thermosetting resin composition applied onto the substrate, the cyclization reaction of the thermosetting resin proceeds, whereby it is possible to form a cured film having excellent heat resistance.

The heating temperature is preferably 50°C to 300°C, more preferably 100°C to 200°C, and particularly preferably 100°C to 180°C.

According to the present invention, since the base (amine species) generated from a thermal base generator can act as a catalyst for the cyclization reaction of the thermosetting resin to promote the cyclization reaction of the thermosetting resin, it is also possible to carry out the cyclization reaction of the thermosetting resin at a lower temperature. Therefore, it is possible to form a cured film having excellent heat resistance even in the treatment at a low temperature of 200°C or lower.

Adjusting at least one selected from the heating rate, the heating time, and the cooling rate is preferred from the viewpoint of internal stress reduction and warpage suppression of a cured film.

The heating rate is preferably 3°C/min to 5°C/min, starting to heat from a temperature of 20°C to 150°C.

In a case where the heating temperature is 200°C to 240°C, the heating time is preferably 180 minutes or more. The upper limit is, for example, preferably 240 minutes or less. In a case where the heating temperature is 240°C to 300°C, the heating time is preferably 90 minutes or more. The upper limit is, for example, preferably 180 minutes or less. In a case where the heating temperature is 300°C to 380°C, the heating time is preferably 60 minutes or more. The upper limit is, for example, preferably 120 minutes or less.

The cooling rate is preferably 1°C/min to 5°C/min.

The heating may be carried out stepwise. An example of heating includes a step in which the temperature is increased at 5°C/min from 20°C to 150°C, allowed to stand at 150°C for 30 minutes, increased at 5°C/min from 150°C to 230°C, and then allowed to stand at 230°C for 180 minutes.

The heating step is preferably carried out in an atmosphere of low oxygen concentration, by flowing of an inert gas such as nitrogen, helium or argon, from the viewpoint of preventing decomposition of a thermosetting resin such as polyimide. The oxygen concentration is preferably 50 ppm or less, and more preferably 20 ppm or less.

In the present invention, a patterning step may be carried out between the step of applying a thermosetting resin composition onto a substrate and the heating step. The patterning step may be carried out, for example, by a photolithography method. For example, there is a method which is carried out through a step of exposing and a step of performing development processing.

The patterning by a photolithography method may be carried out, for example, by using a thermosetting resin composition containing the thermal base generator of the present invention, the above-mentioned thermosetting resin and a photopolymerization initiator. In this case, it is preferred to further contain a polymerizable compound. Moreover, the thermosetting resin preferably has an ethylenically unsaturated bond.

Hereinafter, the case of patterning by a photolithography method will be described.

### «Step of exposing»

In the step of exposing, the thermosetting resin composition applied onto a substrate is irradiated with actinic rays or radiations in a predetermined pattern.

The wavelength of actinic rays or radiations varies depending on the composition of the thermosetting resin composition, and is preferably 200 to 600 nm and more preferably 300 to 450 nm.

As a light source, for example a low-pressure mercury lamp, a high-pressure mercury lamp, an ultra high-pressure mercury lamp, a chemical lamp, an LED light source or an excimer laser generator may be used, and actinic rays having a wavelength of 300 nm to 450 nm such as i-line (365 nm), h-line (405 nm), or g-line (436 nm) may be preferably used. The irradiating light may be adjusted as necessary by way of a spectral filter such as a long wavelength cut filter, a short wavelength cut filter, or a band-pass filter. The exposure dose is preferably 1 to 500 mJ/cm ².

As exposure equipment, various types of exposure equipment such as a mirror projection aligner, a stepper, a scanner, proximity, contact, a microlens array, a lens scanner, and laser exposure may be used.

Incidentally, the photopolymerization of (meth)acrylates and similar olefin unsaturated compounds, as is known, particularly in a thin layer, is prevented by oxygen in the air. This effect may be alleviated by, for example, temporary introduction of the coating layer of a polyvinyl alcohol, or a known conventional method, such as pre-exposure or pre-conditioning in an inert gas.

### «Step of performing development processing»

In the step of performing development processing, an unexposed portion of a thermosetting resin composition is developed using a developer. For example, an aqueous alkaline developer or an organic solvent may be used as the developer.

Examples of an alkali compound used in the aqueous alkaline developer include sodium hydroxide, potassium hydroxide, sodium carbonate, potassium carbonate, sodium hydrogen carbonate, potassium hydrogen carbonate, sodium silicate, potassium silicate, sodium metasilicate, potassium metasilicate, ammonia, and amine. Examples of the amines include ethylamine, n-propylamine, diethylamine, di-n-propylamine, triethylamine, methyldiethylamine, alkanolamine, dimethylethanolamine, triethanolamine, quaternary ammonium hydroxides, tetramethylammonium hydroxide (TMAH), and tetraethylammonium hydroxide. Among them, preferred is a metal-free alkali compound. A suitable aqueous alkaline developer is generally up to 0.5 N in terms of alkali, but may be appropriately diluted before use. For example, about 0.15 to 0.4 N, preferably 0.20 to 0.35 N of an aqueous alkaline developer is also suitable. The alkali compound may be only one type or may be two or more types. In a case where the alkali compound is two or more types, it is preferred that the total thereof is within the above-specified range.

The organic solvents that can be used are the same as the solvents which can be used in the thermosetting resin composition described above. Suitable examples thereof include n-butyl acetate, γ-butyrolactone, cyclopentanone, and a mixture thereof.

The field to which the method of forming a cured film according to the present invention is applicable may be preferably, e.g., an insulating film of semiconductor devices or a re-wiring interlayer insulating film. In particular, since the resolution is good, the method of forming a cured film according to the present invention can be preferably used for, e.g., re-wiring interlayer insulating film in three-dimensional mounting devices.

Further, the method of forming a cured film according to the present invention can also be used in, e.g., photoresists for electronics, (galvanic (electrolysis) resist (galvanic resist), etching resist, or solder top resist).

Further, the method of forming a cured film according to the present invention can also be used in manufacture of printing plates, such as offset printing plates or screen printing plates, for use in etching of molded parts, in electronics, and particularly for production of protective lacquer and dielectric layers in microelectronics.

### <Semiconductor device>

Next, description will be made on one embodiment of a semiconductor device using a thermosetting resin composition for a re-wiring interlayer insulating film.

A semiconductor device 100 shown in Fig. 1 is a so-called three-dimensional mounting device, in which a laminate 101 having a plurality of semiconductor elements (semiconductor chips) 101a to 101d stacked thereon is disposed on a wiring board 120.

In this embodiment, although the description focuses on a case where the number of stacked semiconductor elements (semiconductor chips) is 4 layers, the number of stacked semiconductor elements (semiconductor chips) is not particularly limited and may be, for example, 2 layers, 8 layers, 16 layers, or 32 layers. Further, it may be a single layer.

A plurality of semiconductor elements 101a to 101d are all formed of a semiconductor wafer such as a silicon substrate.

An uppermost semiconductor element 101a does not have a through-electrode, and an electrode pad (not shown) is formed on one surface thereof.

Semiconductor elements 101b to 101d have through-electrodes 102b to 102d, and both surfaces of the respective semiconductor elements are provided with connection pads (not shown) provided integrally with the through-electrodes.

A laminate 101 has a structure in which the semiconductor element 101a having no through-electrode and the semiconductor elements 101b to 101d having the through-electrodes 102b to 102d are flip-chip connected.

In other words, the electrode pad of the semiconductor element 101a having no through-electrode is connected to the connection pad of the semiconductor element 101a side of the semiconductor element 101b having the through-electrode 102b adjacent thereto by a metal bump 103a such as solder bump; and the connection pad of the other side of the semiconductor element 101b having the through-electrode 102b is connected to the connection pad of the semiconductor element 101b side of the semiconductor element 101c having a through-electrode 102c adjacent thereto by a metal bump 103b such as solder bump. Similarly, the connection pad of the other side of the semiconductor element 101c having the through-electrode 102c is connected to the connection pad of a semiconductor element 101c side of the semiconductor element 101d having a through-electrode 102d adjacent thereto by a metal bump 103c such as solder bump.

Underfill layers 110 are formed in gaps of the individual semiconductor elements 101a to 101d, and the individual semiconductor elements 101a to 101d are stacked through underfill layers 110.

A laminate 101 is stacked on a wiring board 120.

As the wiring board 120, for example, a multilayer wiring board using an insulating substrate such as a resin substrate, a ceramic substrate or a glass substrate as a base material is used. As the wiring board 120 onto which the resin substrate is applied, a multilayer copper-clad laminate (multilayer printed wiring board) is exemplified.

On one surface of the wiring board 120 is provided a surface electrode 120a.

An insulating layer 115 on which the re-wiring layer 105 is formed is disposed between the wiring board 120 and the laminate 101, and the wiring board 120 and the laminate 101 are electrically connected via a re-wiring layer 105. The insulating layer 115 is formed of the thermosetting resin composition of the present invention.

That is, one end of the re-wiring layer 105 is connected to the electrode pad formed on the surface of the re-wiring layer 105 side of the semiconductor element 101d via a metal bump 103d such as solder bump. The other end of the re-wiring layer 105 is connected to the surface electrode 120a of the wiring board via a metal bump 103e such as solder bump.

An underfill layer 110a is formed between the insulating layer 115 and the laminate 101. Further, an underfill layer 110b is formed between the insulating layer 115 and the wiring board 120.

### EXAMPLES

Hereinafter, the present invention is further specifically explained with reference to the following Examples, but the present invention is not limited thereto as long as those Examples do not depart from the scope of the present invention. Unless otherwise specified, "%" and "parts" are by mass. NMR is the abbreviation for nuclear magnetic resonance.

### (Synthesis of thermal base generators A-1 to A-9, and A-17)

5 ml of water was placed in a 50 ml eggplant flask which was then stirred at 5°C or lower for 5 minutes. 23 mmol of sodium hydroxide was added, and 23 mmol of chloroacetic acid was added dropwise. 10 mmol of the corresponding arylamine or allylamine was added dropwise, and 4.6 mmol of potassium iodide was added. The temperature was raised to 90°C, followed by stirring for 5 hours. After cooling to room temperature, the precipitated solid was filtered. The resulting solid was re-slurried in 2 ml of water, and then air-dried to give a desired product.

### (Synthesis of thermal base generators A-10 and A-11)

5 ml of water, 10 mmol of aniline, and 10 mmol of glutaconic acid or maleic acid were placed in a 50 ml eggplant flask which was then stirred for 5 minutes. 23 mmol of sodium hydroxide was added, and heating was continued at 100°C for 24 hours. After cooling to room temperature, the precipitated solid was filtered. The resulting solid was re-slurried in 2 ml of water, and then air-dried to give a desired product.

### (Synthesis of thermal base generator A-18)

10 g of phenacyl bromide and 50 mL of acetonitrile were added and dissolved in an eggplant flask, and 11 g of dimethyl dodecylamine was added dropwise thereto. The resulting white precipitate was taken and dissolved in 10 g of methanol. This solution was added dropwise to 100 g of a 10 N aqueous potassium hydroxide solution to give a white precipitate of phenacyl ammonium hydroxide. The precipitate was dissolved in methanol, 1 equivalent of maleic acid was added, and methanol was distilled off to give a desired product.

### (Synthesis of thermal base generators A-19 to A-26)

Thermal base generators A-19 to A-26 were synthesized in the same manner as in A-18, except that the phenacyl bromide, dimethyl dodecylamine, and maleic acid were changed to the corresponding bromide, amine, and carboxylic acid.

### (Synthesis of thermal base generators A-38 to A-42)

Thermal base generators A-38 to A-42 were synthesized in the same manner as in A-18, except that the phenacyl bromide, dimethyl dodecylamine, and maleic acid were changed to the corresponding bromide, amine, and carboxylic acid.

Chemical shift values (in ppm) of proton NMR (400 MHz, solvent: DMSO-d6) as the identification data of thermal base generators A-1, 3, 4, 11, 17 to 24, and A-38 to 41 are shown below.
A-1: 4.4(4H, s), 7.0-7.5(5H, m), 13(2H, br)
A-3: 3.8(3H, s), 4.3(4H, s), 6.7(2H, d), 6.8(2H, d), 13(2H, br)
A-4: 2.4(3H, s), 4.3(4H, s), 7.0(2H, d), 7.8(2H, d), 13(2H, br)
A-11: 2.6-2.9(2H, m), 4.0(1H, m), 5.0(1H, br), 6.5-7.3(5H, m)
A-17: 3.0(2H, m), 3.5(4H, m), 5.2(1H, dd), 5.3(1H, d), 5.7(1H, m), 13(2H, br)
A-18: 0.9(3H, t), 1.1-1.4(18H, m), 1.7(2H, m), 3.2(6H, s), 3.6(2H, s), 5.2(2H, s), 6.1(2H, s), 7.6(2H, m), 7.8(1H, m), 8.0(2H, m)
A-19: 0.9(3H, t), 1.1-1.4(18H, m), 1.7(2H, m), 3.2(6H, s), 3.6(2H, s), 3.9(4H, s), 5.2(2H, s), 6.4(2H, d), 6.6(1H, dd), 7.1(2H, dd), 7.6(2H, m), 7.8(1H, m), 8.0(2H, m)
A-20: 0.9(3H, t), 1.1-1.4(18H, m), 1.7(2H, m), 3.2(6H, s), 3.6(2H, s), 3.9(4H, s), 5.2(2H, s), 7.6(2H, m), 7.8(1H, m), 8.0(2H, m), 8.1(2H, m)
A-21: 0.9(3H, t), 1.1-1.4(18H, m), 1.7(2H, m), 3.2(6H, s), 3.6(2H, s), 3.9(4H, s), 5.2(2H, s), 7.6(2H, m), 7.8(1H, m), 8.0(2H, m)
A-22: 0.9(3H, t), 1.1-1.4(18H, m), 1.7(2H, m), 2.3(4H, s), 3.2(6H, s), 3.6(2H, s), 3.9(4H, s), 5.2(2H, s), 7.6(2H, m), 7.8(1H, m), 8.0(2H, m)
A-23: 0.9(3H, t), 1.1-1.4(18H, m), 1.7(2H, m), 3.2(6H, s), 3.6(2H, s), 5.2(2H, s), 6.1(2H, s), 7.7(2H, m), 7.8-8.2(4H, m), 8.7(1H, s)
A-24: 0.9(3H, t), 1.1-1.4(18H, m), 1.7(2H, m), 3.2(6H, s), 3.6(2H, s), 3.9(4H, s), 5.2(2H, s), 6.4(2H, d), 6.6(1H, dd), 7.1(2H, dd), 7.7(2H, m), 7.8-8.2(4H, m), 8.7(1H, s)
A-38: 0.9(3H, t), 1.1-1.4 (8H, m), 1.7(2H, m), 3.3(6H, s), 3.6(2H, s), 5.2(2H, s), 6.1(2H, s), 7.6(2H, m), 7.8(1H, m), 8.0(2H, m)
A-39: 0.9(3H, t), 1.1-1.4 (10H, m), 1.7(2H, m), 3.3(6H, s), 3.6(2H, s), 5.2(2H, s), 6.1(2H, s), 7.6(2H, m), 7.8(1H, m), 8.0(2H, m)
A-40: 0.9(1H, m), 1.0(2H, m), 1.3 (1H+2H, m), 1.6(2H, m), 3.0(6H, s), 3.6(1H, m), 5.0(2H, s), 5.8(2H, s), 7.4(2H, m), 7.5(1H, m), 7.8(2H, m)
A-41: 3.3(6H, s), 4.8(2H, s), 5.2(2H, s), 6.1(2H, s), 7.5(5H, m), 7.56(2H, m), 7.8(1H, m), 8.0(2H, m)

### (Synthesis Example 1) [Synthesis of polyimide precursor resin (B-1; polyimide precursor resin having no ethylenically unsaturated bond) from pyromellitic dianhydride, 4,4'-oxydianiline and 3-hydroxybenzyl alcohol]

14.06 g (64.5 mmol) of pyromellitic dianhydride (dried at 140°C for 12 hours) and 16.33 g (131.58 mmol) of 3-hydroxybenzyl alcohol were suspended in 50 ml of N-methylpyrrolidone, and dried over a molecular sieve. The suspension was heated for 3 hours at 100°C. A clear solution was obtained a few minutes later after heating. The reaction mixture was cooled to room temperature, and 21.43 g (270.9 mmol) of pyridine and 90 ml of N-methylpyrrolidone were added thereto. Then, the reaction mixture was cooled to -10°C, and 16.12 g (135.5 mmol) of SOCl₂ was added over 10 minutes while maintaining the temperature at -10±4°C. While adding SOCl₂, the viscosity was increased. After dilution with 50 ml of N-methylpyrrolidone, the reaction mixture was stirred at room temperature for 2 hours. Then, a solution of 11.08 g (58.7 mmol) dissolved in 4,4'-oxydianiline in 100 ml of N-methylpyrrolidone was added dropwise to the reaction mixture at 20°C to 23°C over 20 minutes. Then, the reaction mixture was stirred overnight at room temperature. Thereafter, a polyimide precursor resin was precipitated in 5 liters of water, and the water-polyimide precursor resin mixture was stirred for 15 minutes at a speed of 5000 rpm. The polyimide precursor resin was removed by filtration, and stirred again in 4 liters of water for 30 minutes and then filtered again. Then, the resulting polyimide precursor resin was dried under reduced pressure at 45°C for 3 days.

### (Synthesis Example 2) [Synthesis of polyimide precursor resin (B-2; polyimide precursor resin having no ethylenically unsaturated bond) from pyromellitic dianhydride, 4,4'-oxydianiline and benzyl alcohol]

14.06 g (64.5 mmol) of pyromellitic dianhydride (dried at 140°C for 12 hours) and 14.22 g (131.58 mmol) of benzyl alcohol were suspended in 50 ml of N-methylpyrrolidone, and dried over a molecular sieve. The suspension was heated for 3 hours at 100°C. A clear solution was obtained a few minutes later after heating. The reaction mixture was cooled to room temperature, and 21.43 g (270.9 mmol) of pyridine and 90 ml of N-methylpyrrolidone were added thereto. Then, the reaction mixture was cooled to -10°C, and 16.12 g (135.5 mmol) of SOCl₂ was added over 10 minutes while maintaining the temperature at -10±4°C. While adding SOCl₂, the viscosity was increased. After dilution with 50 ml of N-methylpyrrolidone, the reaction mixture was stirred at room temperature for 2 hours. Then, a solution of 11.08 g (58.7 mmol) dissolved in 4,4'-oxydianiline in 100 ml of N-methylpyrrolidone was added dropwise to the reaction mixture at 20°C to 23°C over 20 minutes. Then, the reaction mixture was stirred overnight at room temperature. Thereafter, a polyimide precursor resin was precipitated in 5 liters of water, and the water-polyimide precursor resin mixture was stirred for 15 minutes at a 5000 rpm speed. The polyimide precursor resin was removed by filtration, and stirred again in 4 liters of water for 30 minutes and then filtered again. Then, the resulting polyimide precursor resin was dried under reduced pressure at 45°C for 3 days.

### (Synthesis Example 3) [Synthesis of polyimide precursor resin (B-3; polyimide precursor resin having an ethylenically unsaturated bond) from pyromellitic dianhydride, 4,4'-oxydianiline and 2-hydroxyethyl methacrylate]

14.06 g (64.5 mmol) of pyromellitic dianhydride of (dried at 140°C for 12 hours), 18.6 g (129 mmol) of 2-hydroxyethyl methacrylate, 0.05 g of hydroquinone, 10.7 g of pyridine, and 140 g of diglyme were mixed and the mixture was stirred for 18 hours at a temperature of 60°C to prepare a diester of pyromellitic acid and 2-hydroxyethyl methacrylate. Subsequently, the resulting diester was chlorinated by SOCh, and then converted into a polyimide precursor resin with 4,4'-oxydianiline in the same manner as in Synthesis Example 1. A polyimide precursor resin was obtained in the same manner as in Synthesis Example 1.

### (Synthesis Example 4) [Synthesis of polyimide precursor resin (B-4; polyimide precursor resin having an ethylenically unsaturated bond) from pyromellitic dianhydride, 4,4'-oxydianiline, 3-hydroxybenzyl alcohol and 2-hydroxyethyl methacrylate]

14.06 g (64.5 mmol) of pyromellitic dianhydride (dried at 140°C for 12 hours), 18.6 g (129 mmol) of 2-hydroxyethyl methacrylate, 0.05 g of hydroquinone, 10.7 g of pyridine, and 140 g of diglyme were mixed and the mixture was stirred for 18 hours at a temperature of 60°C to prepare a diester of pyromellitic acid and 2-hydroxyethyl methacrylate.

In addition, 14.06 g (64.5 mmol) of pyromellitic dianhydride (dried at 140°C for 12 hours) and 16.33 g (131.58 mmol) of 3-hydroxybenzyl alcohol were suspended in 50 ml of N-methylpyrrolidone, and dried over a molecular sieve. The suspension was heated for 3 hours at 100°C to prepare a diester of pyromellitic acid and 3-hydroxybenzyl alcohol.

An equimolar mixture of the diester of pyromellitic acid and 2-hydroxyethyl methacrylate and the diester of pyromellitic acid and 3-hydroxybenzyl alcohol was chlorinated by SOCl₂, and then converted into a polyimide precursor resin with 4,4'-oxydianiline in the same manner as in Synthesis Example 1. A polyimide precursor resin was obtained in the same manner as in Synthesis Example 1.

### (Synthesis Example 5) [Synthesis of polyimide precursor resin (B-5; polyimide precursor resin having an ethylenically unsaturated bond) from pyromellitic dianhydride, 4,4'-oxydianiline, benzyl alcohol and 2-hydroxyethyl methacrylate]

14.06 g (64.5 mmol) of pyromellitic dianhydride of (dried at 140°C for 12 hours), 18.6 g (129 mmol) of 2-hydroxyethyl methacrylate, 0.05 g of hydroquinone, 10.7 g of pyridine, and 140 g of diglyme were mixed and the mixture was stirred for 18 hours at a temperature of 60°C to prepare a diester of pyromellitic acid and 2-hydroxyethyl methacrylate.

In addition, 14.06 g (64.5 mmol) of pyromellitic dianhydride (dried at 140°C for 12 hours) and 14.22 g (131.58 mmol) of benzyl alcohol were suspended in 50 ml of N-methylpyrrolidone, and dried over a molecular sieve. The suspension was heated for 3 hours at 100°C to prepare a diester of pyromellitic acid and benzyl alcohol.

An equimolar mixture of the diester of pyromellitic acid and 2-hydroxyethyl methacrylate and the diester of pyromellitic acid and benzyl alcohol was chlorinated by SOCl₂, and then converted into a polyimide precursor resin with 4,4'-oxydianiline in the same manner as in Synthesis Example 1. A polyimide precursor resin was obtained in the same manner as in Synthesis Example 1.

### (Synthesis Example 6) [Synthesis of polyimide precursor resin (B-6; polyimide precursor resin having an ethylenically unsaturated bond) from oxydiphthalic dianhydride, 2-hydroxyethyl methacrylate and 4,4'-diaminodiphenyl ether]

20 g (64.5 mmol) of oxydiphthalic dianhydride was suspended in 140 ml of diglyme, while removing water in a dry reactor equipped with a flat bottom joint with a stirrer, a condenser and an internal thermometer. 16.8 g (129 mmol) of 2-hydroxyethyl methacrylate, 0.05 g of hydroquinone and 10.7 g (135 mmol) of pyridine were then added thereto, followed by stirring at a temperature of 60°C for 18 hours.

Then, after cooling the mixture to -20°C, 16.1 g (135.5 mmol) of thionyl chloride was added dropwise over 90 minutes. A white precipitate of pyridinium hydrochloride was obtained.

The mixture was then warmed to room temperature and stirred for 2 hours, and 9.7 g (123 mmol) of pyridine and 25 ml of N-methylpyrrolidone (NMP) were added to give a clear solution.

Then, 11.8 g (58.7 mmol) of 4,4'-diaminodiphenyl ether dissolved in 100 ml of NMP, and then the reacted solution was added dropwise over 1 hour to the resulting clear liquid. While adding 4,4'-diaminodiphenyl ether, the viscosity was increased.

Then, the mixture was stirred for 2 hours.

The polyimide precursor resin was then precipitated in 4 liters of water, and the water-polyimide precursor resin mixture was stirred for 15 minutes at a speed of 5000 rpm. The polyimide precursor resin was removed by filtration, and stirred again in 4 liters of water for 30 minutes and then filtered again. Then, the resulting polyimide precursor resin was dried under reduced pressure at 45°C for 3 days.

This polyimide precursor resin had a weight-average molecular weight of 25500 and a number-average molecular weight of 3800.

### <Base generation temperature>

Using differential scanning calorimetry (Q2000, manufactured by TA), (A) a thermal base generator was heated to 250°C at 5°C/min in a pressure-resistant capsule. The peak temperature of an exothermic peak having the lowest temperature was read to measure such a peak temperature as a base generation temperature.

### <Test Example 1>

### [Examples 1 to 48 and Comparative Examples 1 to 5]

Components below listed were mixed to prepare a coating solution of a thermosetting resin composition.

### < Composition of thermosetting resin composition>

(A) A thermal base generator: mass% as set forth in the table below
(B) A polyimide precursor resin: mass% as set forth in the table below
(C) A polymerizable compound: mass% as set forth in the table below
(D) A thermal polymerization initiator: mass% as set forth in the table below
(E) A photopolymerization initiator: mass% as set forth in the table below

### (Other components)

### Solvent: γ-butyrolactone: 60 mass%

### [Example 49]

0.2 mass% of 1H-tetrazole with respect to the solid content of the thermosetting resin composition was added to the thermosetting resin composition of Example 43 to prepare a coating solution.

### [Example 50]

0.2 mass% of 1H-tetrazole with respect to the solid content of the thermosetting resin composition was added to the thermosetting resin composition of Example 43 to prepare a coating solution.

### [Example 51]

A coating solution was prepared in the same manner as in Example 49, except that, in the thermosetting resin composition of Example 49, the solvent was changed from 60 mass% of γ-butyrolactone to 48 mass% of γ-butyrolactone and 12 mass% of dimethyl sulfoxide.

### [Example 52]

A coating solution was prepared in the same manner as in Example 49, except that, in the thermosetting resin composition of Example 50, the solvent was changed from 60 mass% of γ-butyrolactone to 48 mass% of γ-butyrolactone and 12 mass% of dimethyl sulfoxide.

Each thermosetting resin composition was pressure-filtered through a filter having a pore width of 0.8 µm, and then spinning-applied (3500 rpm, 30 seconds) onto a silicon wafer. The silicon wafer to which the thermosetting resin composition had been applied was dried on a hot plate at 100°C for 5 minutes to form a uniform resin layer having a thickness of 10 µm on a silicon wafer.

### <Evaluation>

### [Curability]

The thermosetting resin composition was pressure-filtered through a filter having a pore width of 0.8 µm, and then spinning-applied (1200 rpm, 30 seconds) onto a silicon wafer. The silicon wafer onto which the thermosetting resin composition had been applied was dried on a hot plate at 100°C for 5 minutes to form a uniform film having a thickness of 10 µm on a silicon wafer.

The film was scraped from the silicon wafer, and subjected to thermal mass spectrometry in the state of being maintained at 200°C in nitrogen to thereby evaluate the cyclization time. Since the polyimide precursor resin undergoes loss of mass with the progress of a cyclization reaction, the time until the loss of mass would not occur was evaluated according to the following standard. The shorter time indicates a faster cyclization rate, resulting in preferable results.
A: more than 10 minutes and 30 minutes or less
B: more than 30 minutes and 60 minutes or less
C: more than 60 minutes and 120 minutes or less
D: more than 120 minutes and 200 minutes or less
E: more than 200 minutes or no cyclization.

### [Stability]

After preparing a thermosetting resin composition, a container containing 10 g of the thermosetting resin composition was sealed and then allowed to stand under the conditions of 25°C and 65% humidity. Cyclization of the thermosetting resin composition proceeded, and the stability was evaluated in terms of time until the solid was precipitated. The longer time indicates higher stability of the composition, resulting in preferable results. The solid precipitate was filtered through a mesh having a pore size of 0.8 µm, and the presence of mesh-like foreign matter was visually observed.
A: no solid precipitation observed even after 30 days
B: solid precipitation observed after 20 days and within 30 days
C: solid precipitation observed after 10 days and within 20 days
D: solid precipitation observed after 5 days and within 10 days
E: solid precipitation observed within 5 days

### [Resolution]

The thermosetting resin composition was pressure-filtered through a filter having a pore width of 0.8 µm, and then spinning-applied (1200 rpm, 30 seconds) onto a silicon wafer. The silicon wafer onto which the thermosetting resin composition had been applied was dried on a hot plate at 100°C for 5 minutes to form a uniform film having a thickness of 10 µm on a silicon wafer.

The film applied onto the silicon wafer was exposed using an aligner (Karl-Suss MA150). Exposure was carried out by means of a high-pressure mercury lamp, and a light was irradiated at 500 mJ/cm² in terms of exposure energy at a wavelength of 365 nm.

After the exposure was completed, an image was developed in cyclopentanone for 75 seconds. The line width that could have good edge sharpness was evaluated according to the following standard. The smaller line width indicates a larger difference in solubility in a developer between the light-irradiated portion and the non-light irradiated portion, resulting in preferable results.
A: more than 5 µm and 15 µm or less
B: more than 15 µm, or no image shown

### [Adhesiveness]

The thermosetting resin composition was pressure-filtered through a filter having a pore width of 0.8 µm, and then spinning-applied (1200 rpm, 30 seconds) onto a silicon wafer having a copper-deposited layer with a thickness of 1 µm. The silicon wafer onto which the thermosetting resin composition had been applied was dried on a hot plate at 100°C for 5 minutes to form a uniform film having a thickness of 10 µm on a silicon wafer.

Using an aligner (Karl-Suss MA150), the film applied onto the wafer was exposed using a mask such that the image portion was to be a square of 100 µm × 100 µm. Exposure was carried out by means of a high-pressure mercury lamp, and a light was irradiated at 500 mJ/cm² in terms of exposure energy at a wavelength of 365 nm.

After the exposure was completed, an image was developed in cyclopentanone for 75 seconds. A shear adhesive force of the resulting pattern was evaluated by a Shear Tester (manufactured by XYZTec). The greater shear adhesive force indicates higher adhesiveness of the polyimide cured film to a copper surface, resulting in preferable results. 1 kgf = 9.81 N.
A: 40 gf or more
B: more than or equal to 2gf and less than 40 gf
C: less than 2gf

**[Table 6]**

| | (A) Thermal base generator | | (B) Polyimide precursor | | (C) Polymerizable compound | | (D) Thermal polymerization initiator | | (E) Photopolymerization initiator | | Results | | | |
|---|---|---|---|---|---|---|---|---|---|---|---|---|---|---|
| | Type | mass% | Type | mass% | Type | mass% | Type | mass% | Type | mass% | Curability | Stability | Resolution | Adhesiveness |
| Example 1^{∗} | A-1 | 5 | B-1 | 34 | | | | | E-1 | 1 | A | A | A | - |
| Example 2^{∗} | A-1 | 5 | B-2 | 34 | | | | | E-1 | 1 | A | A | A | - |
| Example 3^{∗} | A-1 | 5 | B-3 | 34 | | | | | E-1 | 1 | A | A | A | - |
| Example 4^{∗} | A-1 | 5 | B-4 | 34 | | | | | E-1 | 1 | A | A | A | - |
| Example 5^{∗} | A-1 | 5 | B-5 | 34 | | | | | E-1 | 1 | A | A | A | - |
| Example 6^{∗} | A-2 | 5 | B-3 | 34 | | | | | E-1 | 1 | A | A | A | - |
| Example 7^{∗} | A-3 | 5 | B-3 | 34 | | | | | E-1 | 1 | A | A | A | - |
| Example 8^{∗} | A-4 | 5 | B-3 | 34 | | | | | E-1 | 1 | A | A | A | - |
| Example 9^{∗} | A-5 | 5 | B-3 | 34 | | | | | E-1 | 1 | A | A | A | - |
| Example 10^{∗} | A-6 | 5 | B-3 | 34 | | | | | E-1 | 1 | A | A | A | - |
| Example 11^{∗} | A-7 | 5 | B-3 | 34 | | | | | E-1 | 1 | A | A | A | - |
| Example 12^{∗} | A-8 | 5 | B-3 | 34 | | | | | E-1 | 1 | A | A | A | - |
| Example 13^{∗} | A-9 | 5 | B-3 | 34 | | | | | E-1 | 1 | A | A | A | - |
| Example 14^{∗} | A-10 | 5 | B-3 | 34 | | | | | E-1 | 1 | C | A | A | - |
| Example 15^{∗} | A-11 | 5 | B-3 | 34 | | | | | E-1 | 1 | C | A | A | - |
| Example 16^{∗} | A-12 | 5 | B-3 | 34 | | | | | E-1 | 1 | A | D | A | - |
| Example 17^{∗} | A-13 | 5 | B-3 | 34 | | | | | E-1 | 1 | A | D | A | - |
| Example 18^{∗} | A-14 | 5 | B-3 | 34 | | | | | E-1 | 1 | B | D | A | - |
| Example 19^{∗} | A-15 | 5 | B-3 | 34 | | | | | E-1 | 1 | C | D | A | - |
| Example 20^{∗} | A-16 | 5 | B-3 | 34 | | | | | E-1 | 1 | A | C | A | - |
| Example 21 ^{∗} | A-17 | 5 | B-3 | 34 | | | | | E-1 | 1 | A | B | A | - |
| Example 22^{∗} | A-1 | 5 | B-3 | 29 | C-1 | 5 | | | E-1 | 1 | A | B | A | - |
| Example 23^{∗} | A-1 | 5 | B-3 | 29 | C-2 | 5 | | | E-1 | 1 | A | B | A | - |
| Example 24^{∗} | A-1 | 5 | B-3 | 29 | C-3 | 5 | | | E-1 | 1 | A | B | A | - |
| Example 25^{∗} | A-1 | 4 | B-3 | 29 | C-3 | 5 | D-1 | 1 | E-1 | 1 | A | B | A | - |
| Example 26 | A-18 | 5 | B-1 | 34 | | | | | E-1 | 1 | A | A | A | B |
| Example 27 | A-18 | 5 | B-6 | 34 | | | | | E-1 | 1 | A | A | A | B |
| Example 28 | A-19 | 5 | B-1 | 34 | | | | | E-1 | 1 | A | A | A | B |
| Example 29 | A-20 | 5 | B-1 | 34 | | | | | E-1 | 1 | A | A | A | B |
| Example 30 | A-21 | 5 | B-1 | 34 | | | | | E-1 | 1 | A | A | A | B |
| Example 31 | A-22 | 5 | B-1 | 34 | | | | | E-1 | 1 | A | B | A | B |
| Example 32 | A-23 | 5 | B-1 | 34 | | | | | E-1 | 1 | A | A | A | B |
| Example 33 | A-24 | 5 | B-1 | 34 | | | | | E-1 | 1 | A | A | A | B |
| Example 34 | A-25 | 5 | B-1 | 34 | | | | | E-1 | 1 | B | A | A | B |
| Example 35 | A-26 | 5 | B-1 | 34 | | | | | E-1 | 1 | B | A | A | A |
| Comparative Example 1 | X-1 | 5 | B-3 | 34 | | | | | E-1 | 1 | A | E | B | - |
| Comparative | X-2 | 5 | B-3 | 34 | | | | | E-1 | 1 | A | E | B | - |
| Example 2 | | | | | | | | | | | | | | |
| Comparative Example 3 | X-3 | 5 | B-3 | 34 | | | | | E-1 | 1 | A | E | B | - |
| Example 36 | X-4 | 5 | B-3 | 29 | C-1 | 5 | | | E-1 | 1 | D | D | A | - |
| Example 37 | X-5 | 5 | B-3 | 29 | C-2 | 5 | | | E-1 | 1 | D | D | A | - |
| Example 38 | X-6 | 5 | B-3 | 29 | C-3 | 5 | | | E-1 | 1 | D | D | A | - |
| Example 39 | X-7 | 5 | B-3 | 29 | C-3 | 5 | | | E-1 | 1 | D | B | A | - |
| Example 40 | X-8 | 5 | B-3 | 29 | C-3 | 5 | | | E-1 | 1 | D | B | A | - |
| Comparative Example 4 | | | B-1 | 39 | | | | | E-1 | 1 | E | A | A | - |
| Comparative Example 5 | X-9 | 5 | B-3 | 34 | | | | | E-1 | 1 | A | E | B | - |
| Example 41^{∗} | A-1 | 5 | B-1 | 29 | C-1 | 5 | | | E-1 | 1 | A | A | A | - |
| Example 42 | A-18 | 5 | B-6 | 29 | C-1 | 5 | | | E-1 | 1 | A | A | A | B |
| Example 43 | A-18 | 5 | B-6 | 29 | C-2 | 5 | | | E-1 | 1 | A | A | A | B |
| Example 44 | A-18 | 5 | B-6 | 29 | C-3 | 5 | | | E-1 | 1 | A | A | A | B |
| Example 45 | A-18 | 5 | B-6 | 29 | C-2 | 5 | | | E-2 | 1 | A | A | A | B |
| Example 46 | A-18 | 5 | B-6 | 29 | C-3 | 5 | | | E-3 | 1 | A | A | A | B |
| Example 47 | A-18 | 5 | B-6 | 29 | C-2 | 5 | | | E-4 | 1 | A | A | A | B |
| Example 48 | A-18 | 5 | B-6 | 29 | C-3 | 5 | | | E-5 | 1 | A | A | A | B |
| Example 49 | A-18 | 5 | B-6 | 29 | C-2 | 5 | | | E-1 | 1 | A | A | A | B |
| Example 50 | A-18 | 5 | B-6 | 29 | C-3 | 5 | | | E-1 | 1 | A | A | A | B |
| Example 51 | A-18 | 5 | B-6 | 29 | C-2 | 5 | | | E-1 | 1 | A | A | A | B |
| Example 52 | A-18 | 5 | B-6 | 29 | C-3 | 5 | | | E-1 | 1 | A | A | A | B |

| | | | | | | | | | | | | | | |
|---|---|---|---|---|---|---|---|---|---|---|---|---|---|---|
| ^{∗}Reference Examples that are not within the scope of the present claims. | | | | | | | | | | | | | | |

**[Table 7]**

| | (A) Thermal base generator | | (B) Polyimide precursor | | (C) Polymerizable compound | | (E) Photopolymerization initiator | | Results | | | |
|---|---|---|---|---|---|---|---|---|---|---|---|---|
| | Type | mass% | Type | mass% | Type | mass% | Type | mass% | Curability | Stability | Resolution | Adhesiveness |
| Example 53 | Composition where Compound C is added to compound described in Example 43 so as to be 0.2 mass% with respect to solid content of composition | | | | | | | | A | A | A | B |
| Example 54 | Composition where Compound C is added to compound described in Example 44 so as to be 0.2 mass% with respect to solid content of composition | | | | | | | | A | A | A | B |
| Example 55 | Composition where Compound C is added to compound described in Example 49 so as to be 0.2 mass% with respect to solid content of composition | | | | | | | | A | A | A | B |
| Example 56 | Composition where Compound C is added to compound described in Example 50 so as to be 0.2 mass% with respect to solid content of composition | | | | | | | | A | A | A | B |
| Example 57 | Composition where solvent of Example 55 is changed to a mixed solvent (γ-butyrolactone 48 mass%/dimethylsulfoxide 12 mass%) | | | | | | | | A | A | A | B |
| Example 58 | Composition where solvent of Example 56 is changed to a mixed solvent (γ-butyrolactone 48 mass%/dimethylsulfoxide 12 mass%) | | | | | | | | A | A | A | B |
| Example 59 | A-38 | 5 | B-6 | 29 | C-1 | 5 | E-1 | 1 | A | A | A | A |
| Example 60 | A-39 | 5 | B-6 | 29 | C-1 | 5 | E-1 | 1 | A | A | A | A |
| Example 61 | A-40 | 5 | B-6 | 29 | C-1 | 5 | E-1 | 1 | A | A | A | A |
| Example 62 | A-41 | 5 | B-6 | 29 | C-1 | 5 | E-1 | 1 | A | A | A | A |
| Example 63 | A-42 | 5 | B-6 | 29 | C-1 | 5 | E-1 | 1 | A | A | A | A |

From the above results, the thermosetting resin compositions of the Examples were found to have excellent curability and stability. Furthermore, resolution was excellent. In addition, good results were obtained even in a case where E-1 instead of DAROCUR-1173 or IRGACURE-907 (both manufactured by BASF Corp.) was used as a photopolymerization initiator.

In contrast, the thermosetting resin compositions of the Comparative Examples were inferior in at least one of curability and stability than the thermosetting resin compositions of the Examples. In addition, Comparative Examples 1 to 3 exhibited inferior resolution.

Abbreviations described in Tables 6 and 7 are shown below.

### (A) Thermal base generator

Thermal base generators A-1 to A-11, A-17 to A-26, A-38 to A-42: The structure was a structure shown in specific examples of the above-mentioned thermal base generator, all of which are synthetic.

**[Table 8]**

| Structure | Available from | Base generation temperature |
|---|---|---|
| 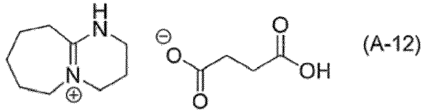 | 1:1 mixture of diazabicycloundecene and succinic acid (both available from Tokyo Chemical Industry Co., Ltd.) | 150°C |
| 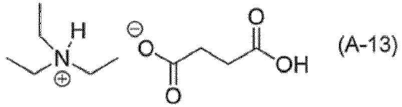 | 1:1 mixture of triethylamine and succinic acid (both available from Tokyo Chemical Industry Co., Ltd.) | 170°C |
| 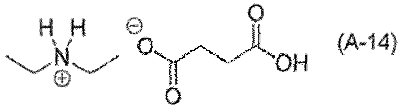 | 1:1 mixture of diethylamine and succinic acid (both available from Tokyo Chemical Industry Co., Ltd.) | 170°C |
| 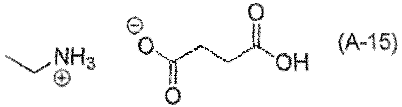 | 1:1 mixture of monoethylamine and succinic acid (both available from Tokyo Chemical Industry Co., Ltd.) | 170°C |
| 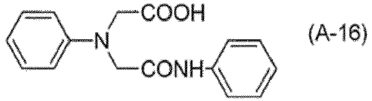 | Wako Pure Chemical Industries Ltd. | 130°C |

·X-1 to X-9: Structures shown below (in the formulae, Me represents a methyl group).

**[Table 9]**

| Structure | Available from | Base generation temperature pKal of anion |
|---|---|---|
| 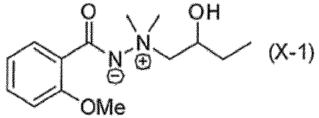 | Synthesized by the method described in WO2009/084229A | 80°C |
| 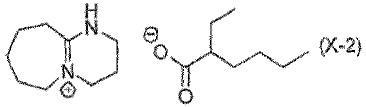 | Manufactured by San-Apro Ltd. | 90°C pKal=5.0 |
| 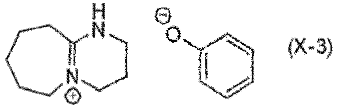 | Manufactured by San-Apro Ltd. | 90°C pKal=10.0 |
| 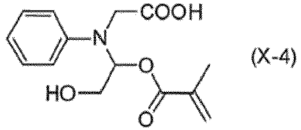 | Synthesized by the method described in JP2006-282880A | Higher than 200°C |
| 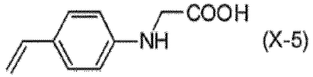 | Synthesized by the method described in JP2006-282880A | Higher than 200°C |
| 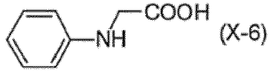 | Manufactured by Wako Pure Chemical Industries Ltd. | Higher than 200°C |
| 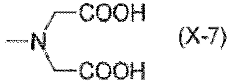 | Manufactured by Wako Pure Chemical Industries Ltd. | Higher than 200°C |
| 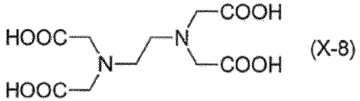 | Manufactured by Wako Pure Chemical Industries Ltd. | Higher than 200°C |
| 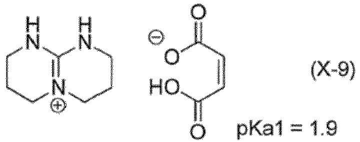 | 1:1 mixture of 1,5,7-triazabicyclo[4.4.0]dec-5 -ene and maleic acid (both available from Tokyo Chemical Industry Co., Ltd. ) | Lower than 40°C |

### (B) Polyimide precursor resins

B-1 to B-6: Polyimide precursor resins B-1 to B-6 synthesized in Synthesis Examples 1 to 5

### (C) Polymerizable compound

C-1: NK ester M-40G (monofunctional methacrylate of the following structure manufactured by Shin-Nakamura Chemical Co., Ltd.) 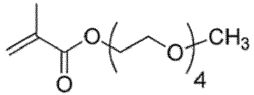
C-2: NK ester 4G (bifunctional methacrylate of the following structure manufactured by Shin-Nakamura Chemical Co., Ltd.) 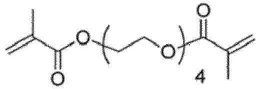
(C-3) NK ester A-9300 (trifunctional acrylate of the following structure manufactured by Shin-Nakamura Chemical Co., Ltd.)

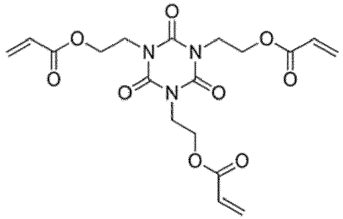

### (D) Thermal polymerization initiator

D-1: PERBUTYL Z (manufactured by NIPPON OIL & FATS CO., LTD., tert-butyl peroxybenzoate, decomposition temperature (10-hour half-life temperature = 104°C))

### (E) Photopolymerization initiator

E-1: IRGACURE OXE-01 (manufactured by BASF Corp.) 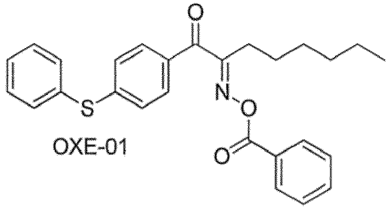
E-2: Compound 24 described in paragraph "0345" of JP2014-500852A
E-3: Compound 36 described in paragraph "0345" of JP2014-500852A
E-4: Compound 37 described in paragraph "0345" of JP2014-500852A
E-5: Compound 40 described in paragraph "0345" of JP2014-500852A

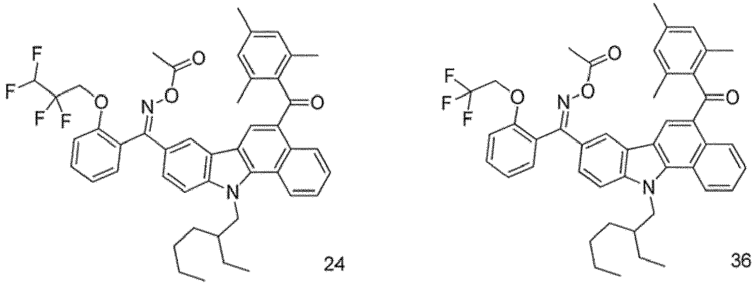

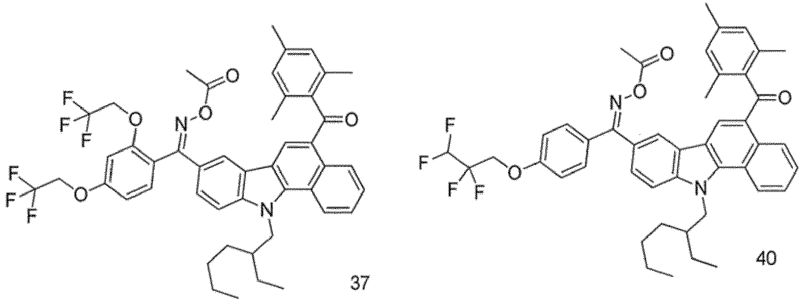

### Compound C: 90316, manufactured by Aldrich Co., Ltd.

Compound C used in Examples 53 to 56 is as follows.

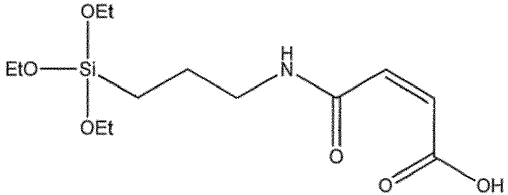

### <Example 100>

The thermosetting resin composition of Example 1 was pressure-filtered through a filter having a pore width of 0.8 µm, and then spinning-applied (3500 rpm, 30 seconds) onto a resin substrate having a copper thin layer formed thereon. The thermosetting resin composition applied onto the resin substrate was dried at 100°C for 5 minutes.

This was then followed by heating at 180°C for 20 minutes. In this manner, a re-wiring interlayer insulating film was formed.

This re-wiring interlayer insulating film exhibited excellent insulating properties.

Further, as a result of manufacturing a semiconductor device by using this re-wiring interlayer insulating film, it was confirmed that the semiconductor device thus prepared worked without problems.

In addition, similar effects were obtained even in a case where the polyimide precursor resin was changed to a polyamideimide precursor resin or a polybenzoxazole precursor.

### Explanation of References

100: semiconductor device
101a to 101d: semiconductor elements
101: laminate
102b to 102d: through-electrodes
103a to 103e: metal bumps
105: re-wiring layer
110, 110a and 110b: underfill layers
115: insulating layer
120: wiring board
120a: surface electrode

## Claims

1. A thermal base generator, comprising an acidic compound which is an ammonium salt containing a carboxylic acid anion having a pKa1 of 0-4 and an ammonium cation, wherein
(a) the carboxylic acid anion
- is of the Formula EWG-C(=O)-O^{⊝} (X1), wherein EWG is an electron-withdrawing group selected from (EWG-1) to (EWG-6): 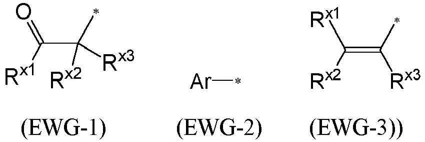 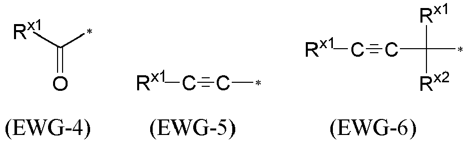 wherein R^{x1}-R^{x3} each independently are H, alkyl, alkenyl, aryl, hydroxyl or carboxyl, and Ar is an aromatic ring group; or
- is a di- or higher-valent, preferably a divalent, anion of carboxylic acid having two or more carboxyl groups, more preferably an anion of the formula (X): 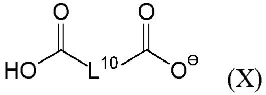 wherein L¹⁰ is a single bond, or a divalent linking group selected from alkylene, alkenylene, arylene, -NR^{X}- and a combination thereof, and R^{X} is H, alkyl, alkenyl or aryl,
and particularly preferably is selected from a maleic acid anion, a phthalic acid anion, an N-phenyliminodiacetic acid anion and an oxalic acid anion; and
(b) the ammonium cation is of the formula (Y1-1) or (Y1-2): 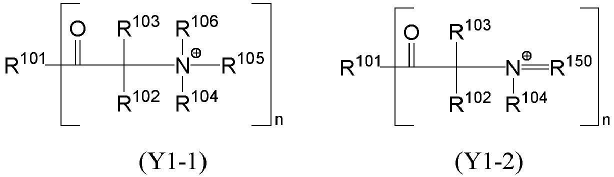 wherein
R¹⁰¹ is an n-valent organic group,
R¹⁰²-R¹⁰⁶ each independently are H or a hydrocarbon group,
R¹⁵⁰ is a hydrocarbon group, and R¹⁰⁴ and R¹⁰⁵, and R¹⁰⁴ and R¹⁵⁰ may be bonded to each other to form a ring, and
n is an integer of ≥ 1,
and preferably the ammonium cation is of the formula (Y1-1) or (Y1-2) wherein R¹⁰¹ is an aromatic ring group.

2. A composition, which is a thermosetting resin composition comprising the thermal base generator of claim 1 and a thermosetting resin.

3. The composition of claim 2, wherein the thermosetting resin is a thermosetting resin which is cyclized to be cured by the action of a base.

4. The composition of claim 2 or 3, wherein the thermosetting resin is at least one selected from a polyimide precursor resin, a polyamideimide precursor resin and a polybenzoxazole precursor resin.

5. The composition of any of claims 2-4, wherein the thermosetting resin has an ethylenically unsaturated bond.

6. The composition of any of claims 2-5, wherein the thermosetting resin contains a repeating unit of formula (2) or (3): 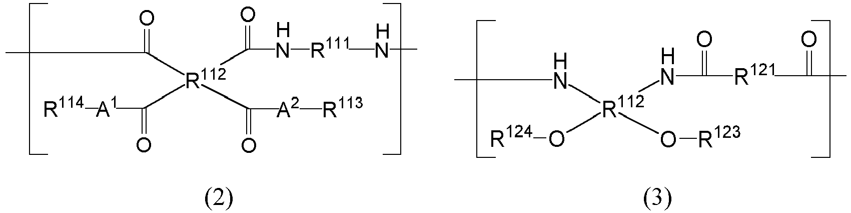 wherein
A¹, A² each independently are -O- or -NH-,
R¹¹¹ is a divalent organic group,
R¹¹² is a tetravalent organic group,
R¹¹³, R¹¹⁴ each independently are H or a monovalent organic group,
R¹²¹ is a divalent organic group, R¹²² is a tetravalent organic group, and
R¹²³, R¹²⁴ each independently are H or a monovalent organic group.

7. The composition of claim 6, wherein at least one of R¹¹³ or R¹¹⁴ in formula (2), or at least one of R¹²³ or R¹²⁴ in formula (3) has an ethylenically unsaturated bond.

8. The composition of any of claims 2-7, further comprising a polymerizable compound, which is a compound having at least one, preferably two or more, ethylenically unsaturated bond(s), and more preferably is a compound having a partial structure of the following formulae where ^{∗} is a connecting portion.

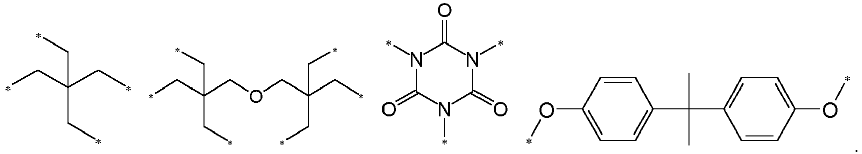

9. The composition of any of claims 2-8, further comprising a thermal polymerization initiator, and preferably a thermal polymerization initiator which is a peroxide.

10. The composition of any of claims 2-9, further comprising a photopolymerization initiator.

11. A cured film formed by curing the composition of any of claims 2-10.

12. The cured film of claim 11, which is a re-wiring interlayer insulating film.

13. A method for manufacturing a cured film, comprising applying the composition of any of claims 2-10 onto a substrate; and curing the composition applied onto the substrate.

14. A semiconductor device including the cured film of claim 11, or a cured film prepared by the method of claim 13.

## Patentansprüche

1. Thermischer Basenerzeuger, umfassend eine saure Verbindung, die ein Ammoniumsalz ist, das ein Carbonsäureanion mit einem pKa1 von 0-4 und ein Ammoniumkation enthält, worin
(a) das Carbonsäureanion
- der Formel EWG-C(=O)-O^{⊝} (X1) entspricht, worin EWG eine elektronenziehende Gruppe ist, die aus (EWG-1) bis (EWG-6) ausgewählt ist: 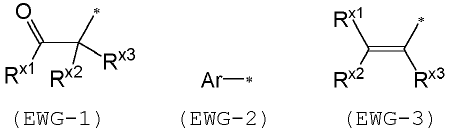 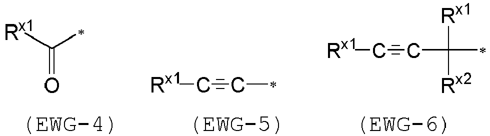 worin R^{x1}-R^{x3} jeweils unabhängig für H, Alkyl, Alkenyl, Aryl, Hydroxyl oder Carboxyl stehen und Ar eine aromatische Ringgruppe ist; oder
- ein zwei- oder höherwertiges, vorzugsweise zweiwertiges, Anion einer Carbonsäure mit zwei oder mehreren Carboxylgruppen, bevorzugter ein Anion der Formel (X) ist: 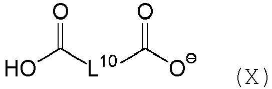 worin L¹⁰ für eine Einfachbindung oder eine zweiwertige Verknüpfungsgruppe steht, ausgewählt aus Alkylen, Alkenylen, Arylen, - NR^{X}- und einer Kombination daraus, und R^{X} für H, Alkyl, Alkenyl oder Aryl steht,
und besonders bevorzugt ausgewählt ist aus einem Maleinsäureanion, einem Phthalsäureanion, einem N-Phenyliminodiessigsäureanion und einem Oxalsäureanion; und
(b) das Ammoniumkation der Formel (Y1-1) oder (Y1-2) entpricht: 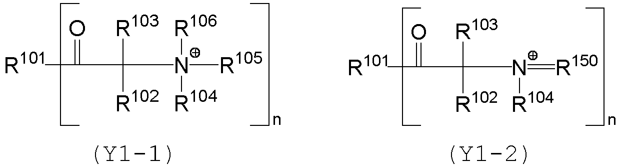 worin
R¹⁰¹ für eine n-wertige organische Gruppe steht,
R¹⁰²-R¹⁰⁶ jeweils unabhängig für H oder eine Kohlenwasserstoffgruppe stehen,
R¹⁵⁰ für eine Kohlenwasserstoffgruppe steht, und R¹⁰⁴ und R¹⁰⁵, und R¹⁰⁴ und R¹⁵⁰ aneinander gebunden sein können, so dass ein Ring gebildet wird, und
n eine ganze Zahl von ≥ 1 ist,
und vorzugsweise entspricht das Ammoniumkation der Formel (Y1-1) oder (Y1-2), worin R¹⁰¹ für eine aromatische Ringgruppe steht.

2. Zusammensetzung, die eine thermohärtende Harzzusammensetzung ist, umfassend den thermischen Basenerzeuger von Anspruch 1 und ein thermohärtendes Harz.

3. Zusammensetzung gemäß Anspruch 2, worin das thermohärtende Harz ein thermohärtendes Harz ist, das zur Härtung durch die Wirkung einer Base cyclisiert wird.

4. Zusammensetzung gemäß Anspruch 2 oder 3, worin das thermohärtende Harz mindestens eines ist, ausgewählt aus einem Polyimidvorläuferharz, einem Polyamidimidvorläuferharz und einem Polybenzoxazolvorläuferharz.

5. Zusammensetzung gemäß einem der Ansprüche 2-4, worin das thermohärtende Harz eine ethylenisch ungesättigte Bindung aufweist.

6. Zusammensetzung gemäß einem der Ansprüche 2-5, worin das thermohärtende Harz eine Wiederholungseinheit der Formel (2) oder (3) enthält: 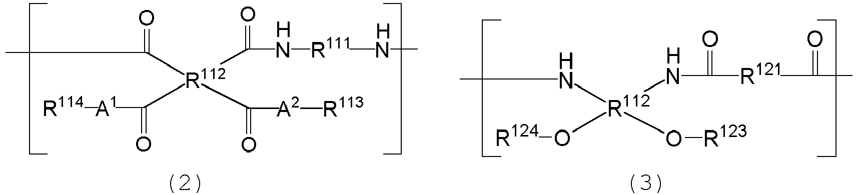 worin
A¹, A² jeweils unabhängig für -O- oder -NH- stehen,
R¹¹¹ für eine zweiwertige organische Gruppe steht,
R¹¹² für eine vierwertige organische Gruppe steht,
R¹¹³, R¹¹⁴ jeweils unabhängig für H oder eine einwertige organische Gruppe stehen,
R¹²¹ für eine zweiwertige organische Gruppe steht, R¹²² für eine vierwertige organische Gruppe steht und
R¹²³, R¹²⁴ jeweils unabhängig für H oder eine einwertige organische Gruppe stehen.

7. Zusammensetzung gemäß Anspruch 6, worin mindestens eines von R¹¹³ oder R¹¹⁴ in Formel (2) oder mindestens eines von R¹²³ oder R¹²⁴ in Formel (3) eine ethylenisch ungesättigte Bindung aufweist.

8. Zusammensetzung gemäß einem der Ansprüche 2-7, ferner umfassend eine polymerisierbare Verbindung, die eine Verbindung mit mindestens einer ethylenisch ungesättigten Bindung, vorzugsweise zwei oder mehreren davon, ist und bevorzugter eine Verbindung ist, die eine Teilstruktur der folgenden Formeln aufweist, in denen * einen Verbindungsabschnitt darstellt.

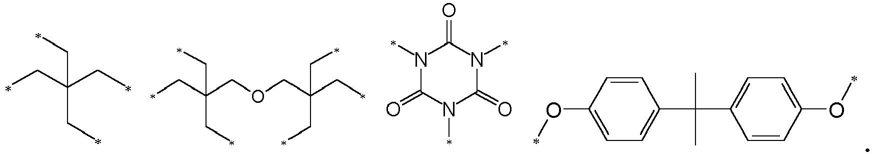

9. Zusammensetzung gemäß einem der Ansprüche 2-8, ferner umfassend einen thermischen Polymerisationsinitiator und vorzugsweise einen thermischen Polymerisationsinitiator, der ein Peroxid ist.

10. Zusammensetzung gemäß einem der Ansprüche 2-9, ferner umfassend einen Photopolymerisationsinitiator.

11. Gehärteter Film, der durch Härten der Zusammensetzung gemäß einem der Ansprüche 2-10 gebildet ist.

12. Gehärteter Film gemäß Anspruch 11, der ein Umverdrahtungszwischenisolierfilm ist.

13. Verfahren zur Herstellung eines gehärteten Films, umfassend das Auftragen der Zusammensetzung gemäß einem der Ansprüche 2-10 auf ein Substrat; und das Härten der auf das Substrat aufgetragenen Zusammensetzung.

14. Halbleiterbauteil, das den gehärteten Film von Anspruch 11 oder einen gehärteten Film, der durch das Verfahren von Anspruch 13 hergestellt ist, umfasst.

## Revendications

1. Générateur de base thermique, comprenant un composé acide qui est un sel d'ammonium contenant un anion acide carboxylique présentant un pka1 de 0-4 et un cation ammonium, dans lequel
(a) l'anion acide carboxylique
- est de la formule EWG-C(=O)-O^{θ} (X1), EWG étant un groupe attracteur d'électrons choisi parmi (EWG-1) à (EWG-6) : 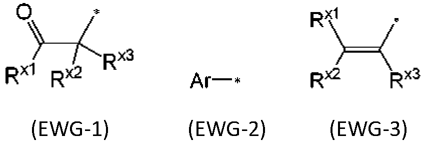 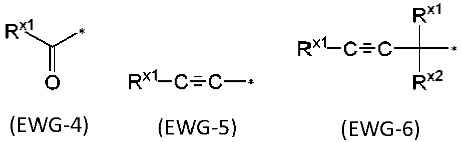 dans lequel R^{x1} à R^{x3} sont chacun indépendamment H, un alkyle, un alcényle, un aryle, un hydroxyle ou un carboxyle, et Ar est un groupe cyclique aromatique ; ou
- est un anion divalent ou plus, de préférence un anion divalent, d'acide carboxylique présentant deux groupes carboxyle ou plus, plus préférentiellement un anion de formule (X) : 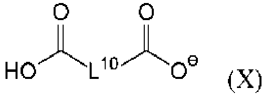 L¹⁰ étant une liaison simple ou un groupe de liaison divalent choisi parmi alkylène, alcénylène, arylène, -NR^{X}- et une combinaison de ceux-ci, et R^{x} est H, un alkyle, un alcényle ou un aryle,
et particulièrement de préférence est choisi parmi un anion acide maléique, un anion acide phtalique, un anion acide N-phényliminodiacétique et un anion acide oxalique ; et
(b) le cation ammonium est de la formule (Y1-1) ou (Y1-2) : 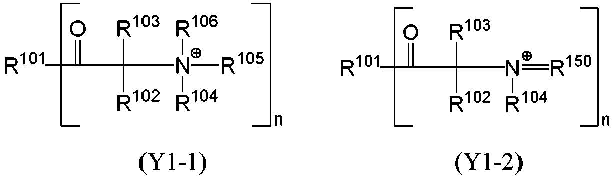 dans lequel
R¹⁰¹ est un groupe organique n-valent,
R¹⁰²-R¹⁰⁶ représentent chacun indépendamment H ou un groupe hydrocarboné,
R¹⁵⁰ est un groupe hydrocarboné, et R¹⁰⁴ et R¹⁰⁵, et R¹⁰⁴ et R¹⁵⁰ peuvent être liés l'un à l'autre pour former un cycle, et
n est un entier ≥ 1,
et de préférence le cation ammonium est de la formule (Y1-1) ou (Y1-2) dans lequel R¹⁰¹ est un groupe cyclique aromatique.

2. Composition, qui est une composition de résine thermodurcissable comprenant le générateur de base thermique selon la revendication 1, et une résine thermodurcissable.

3. Composition selon la revendication 2, dans laquelle la résine thermodurcissable est une résine thermodurcissable qui est cyclisée pour être durcie par l'action d'une base.

4. Composition selon la revendication 2 ou 3, dans laquelle la résine thermodurcissable est au moins une résine choisie parmi une résine précurseur de polyimide, une résine précurseur de polyamideimide et une résine précurseur de polybenzoxazole.

5. Composition selon l'une quelconque des revendications 2-4, dans laquelle la résine thermodurcissable présente une liaison à insaturation éthylénique.

6. Composition selon l'une quelconque des revendications 2-5, dans laquelle la résine thermodurcissable contient un motif répétitif de formule (2) ou (3) : 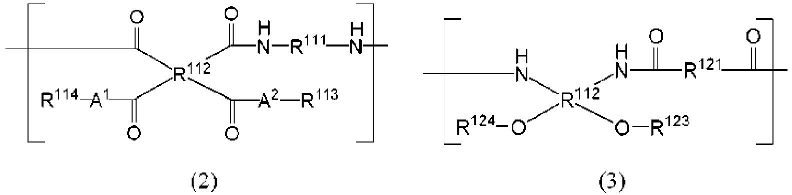 dans laquelle
A¹, A² sont chacun indépendamment -O- ou -NH-,
R¹¹¹ est un groupe organique divalent,
R¹¹² est un groupe organique tétravalent,
R¹¹³, R¹¹⁴ représentent chacun indépendamment H ou un groupe organique monovalent,
R¹²¹ est un groupe organique divalent, R¹²² est un groupe organique tétravalent, et
R¹²³, R¹²⁴ représentent chacun indépendamment H ou un groupe organique monovalent.

7. Composition selon la revendication 6, dans laquelle au moins un parmi R¹¹³ ou R¹¹⁴ dans la formule (2), ou au moins un parmi R¹²³ ou R¹²⁴ dans la formule (3) présente une liaison à insaturation éthylénique.

8. Composition selon l'une quelconque des revendications 2-7, comprenant en outre un composé polymérisable, qui est un composé présentant au moins une, de préférence deux ou plus, liaison(s) à insaturation éthylénique, et plus préférentiellement est un composé présentant une structure partielle de la formule suivante où ^{∗} est une partie de connexion.

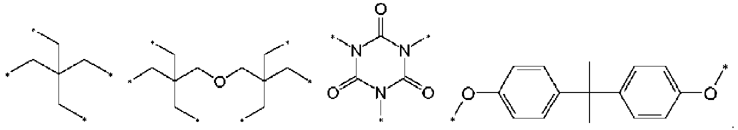

9. Composition selon l'une quelconque des revendications 2-8, comprenant en outre un initiateur de polymérisation thermique, et de préférence un initiateur de polymérisation thermique qui est un peroxyde.

10. Composition selon l'une quelconque des revendications 2-9, comprenant en outre un initiateur de photopolymérisation.

11. Film durci formé par durcissement de la composition selon l'une quelconque des revendications 2-10.

12. Film durci selon la revendication 11, qui est un film isolant de couche intermédiaire de recâblage.

13. Procédé de fabrication d'un film durci, comprenant une application de la composition selon l'une quelconque des revendications 2-10 sur un substrat; et un durcissement de la composition appliquée sur le substrat.

14. Dispositif à semi-conducteur incluant le film durci selon la revendication 11, ou un film durci préparé par le procédé de la revendication 13.
